(19) Europäisches Patentamt
European Patent Office
Office européen des brevets

(11) **EP 2 639 962 B1**

(12) **EUROPEAN PATENT SPECIFICATION**

(45) Date of publication and mention
of the grant of the patent:
**07.01.2015 Bulletin 2015/02**

(51) Int Cl.:
**H03M 13/11** *(2006.01)*

(21) Application number: **12305308.4**

(22) Date of filing: **15.03.2012**

(54) **Joint message-passing decoding of a differential code and a channel code**

Gemeinsame Message-Passing Decodierung eines Differenzial- und eines Kanalcodes

Décodage conjoint de code différentiel et de code canal par passage de messages

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.09.2013 Bulletin 2013/38**

(73) Proprietor: **ALCATEL LUCENT
92100 Boulogne-Billancourt (FR)**

(72) Inventors:
- **Schmalen, Laurent
70469 Stuttgart (DE)**
- **Leven, Andreas
74321 Bietigheim-Bissingen (DE)**
- **Ten Brink, Stephan
70469 Stuttgart (DE)**

(74) Representative: **Knecht, Ulrich Karl
Alcatel-Lucent Deutschland AG
Intellectual Property Group
Lorenzstrasse 10
70435 Stuttgart (DE)**

(56) References cited:
- **JIANRONG BAO ET AL: "Concatenated eIRA Codes for Tamed Frequency Modulation", IEEE INTERNATIONAL CONFERENCE ON COMMUNICATIONS, 2008 : ICC '08 ; 19 - 23 MAY 2008, BEIJING, CHINA, IEEE, PISCATAWAY, NJ, USA, 19 May 2008 (2008-05-19), pages 1886-1891, XP031265683, ISBN: 978-1-4244-2075-9**
- **MANSOUR M M: "High-performance decoders for regular and irregular repeat-accumulate codes", GLOBAL TELECOMMUNICATIONS CONFERENCE, 2004. GLOBECOM '04. IEEE DALLAS, TX, USA 29 NOV.-3 DEC., 2004, PISCATAWAY, NJ, USA,IEEE, PISCATAWAY, NJ, USA, vol. 4, 29 November 2004 (2004-11-29), pages 2583-2588, XP010757993, DOI: 10.1109/GLOCOM.2004.1378472 ISBN: 978-0-7803-8794-2**

## Description

Embodiments of the present invention relate to communication networks, more particularly but not exclusively to decoding a codeword received through an optical channel.

Background

Conventional communication systems mostly comprise a backbone part and an access part. For example, a wireless communication network may comprise a Radio Network Access (RAN) part, which establishes and controls the wireless access, and a Core Network (CN), through which other networks and other users of the wireless communication network are connected. Another example of a packet data or a packet switched communication network is the communication network established between the servers and routers of the World Wide Web (WWW). With the steady increases of data demand, interfaces and networks are improved to handle the increased load. For wired connections in the network, optical data transmission using fibers is used to enhance the link capacity between such interfaces.

In communications systems, such as systems using optical data transmission, wireless, wireline or powerline communications, digital data values may be transmitted by means of an optical transmission signal. The optical transmission signal is generated by modulating the phase and/or the amplitude of an optical carrier signal, which possesses a carrier frequency, in dependence on the transmitted data values and in accordance with a constellation diagram of a respective phase-shift keying (PSK) modulation or Quadrature Amplitude Modulation (QAM) method. Prominent examples are Binary Phase Shift Keying (BPSK), Quaternary Phase Shift Keying (QPSK), 16 QAM, 64 QAM, etc.

Each point of the constellation diagram represents a finite set of data values that are to be transmitted, wherein the set of data values is called a data symbol. A data symbol is represented by a corresponding constellation point of a constellation diagram, wherein the constellation point has a corresponding symbol phase and amplitude value. Depending on the data symbols that are to be transmitted, respective constellation points and symbol phase values are derived. The phase and the amplitude of the optical carrier signal are modulated, such that it corresponds to the derived symbol phase values and amplitude values representing the respective data symbols.

When using a pure PSK modulation method, only the phase is modulated, while the amplitude is kept constant. When using a QAM method, the phase is modulated just as in a PSK scheme, but also the amplitude is modulated for obtaining a higher data rate. Thus, a QAM method may be interpreted as a PSK modulation method with an additional amplitude modulation. Therefore, the term PSK modulation method shall include a pure PSK modulation method as well as a QAM method herein.

An example for a phase-shift keying modulation method is BPSK, in which each point of the corresponding constellation diagram represents one bit and in which adjacent constellation points are separated by a separation angle that has an absolute value of 180° or $\pi$. In QPSK each constellation point represents a data symbol consisting of two bits and adjacent constellation points are separated by a separation angle that has an absolute value of 90° or $\pi/2$. At a receiving side, received data values may be derived, by carrying out a coherent reception scheme: the received optical transmission signal is mixed with a coherent optical signal that possesses the carrier frequency and a phase, which is ideally equal to the phase of the optical carrier signal used at the transmitting side. This mixing yields a resulting optical baseband signal. The optical baseband signal is converted to a sampled electrical signal via analogue-digital conversion, and the phase of the sampled electrical signal is estimated for deriving received data values.

When using a hard decision detection scheme, it is decided for that point of the constellation diagram, which has a symbol phase value most similar to the estimated phase of the received optical carrier signal. Corresponding data symbols and corresponding data values are then derived from the estimated symbol phase values. When transmitting an optical signal over an optical transmission channel, the signal's phase may be degraded by a phase offset that may be estimated at the receiver. The phase of the PSK modulated optical signal may then be corrected by this estimated phase offset. The estimated phase offset may be erroneous to a degree, such that the correction of the received optical signal causes a rotation of the PSK constellation diagram by a whole numbered multiple of the separation angle from the receiver's perspective. Such a rotation of the constellation diagram occurs from the time instance of one data symbol to a next time instance of a next successive data symbol and is called a phase slip. A typical value for a probability of a phase slip is for example $10^{-3}$.

When relying on a hard decision detection scheme at the receiver, the effects of a phase slip are the following: If a phase slip causes a rotation of the constellation diagram at a certain time instance, and if the constellation diagram maintains to be rotated for further time instances, then this leads to false derived data values for the certain time instance and for the further time instances.

A known countermeasure against phase slips is the technique of differential coding. On the transmission side, the derived data symbols are differentially encoded into differentially encoded data symbols, such that a derived data symbol is represented by a transition from one differentially encoded data symbol to a next successive differentially encoded data symbol. The differentially encoded data symbols are then mapped onto the PSK constellation diagram.

On the receiving side, the received differentially encoded data symbols are observed. Differential decoding may be performed, by deriving a differentially decoded data symbol from a transition from one differentially encoded data symbol to a next differentially encoded data symbol. In other words, data symbols are derived at the receiver by phase changes between successive received differentially encoded data symbols. The derived differentially decoded data symbols represent differentially decoded data values, as previously mentioned.

When relying on differential encoding in combination with a hard decision detection scheme at the receiver, the effects of a phase slip are the following: If a phase slip causes a rotation of the constellation diagram at a certain time instance, and if the rotation of the constellation diagram prevails for next further time instances, then this leads to false derived data values for the certain time instance but not for the next further time instances; but, if a phase slip causes a rotation of the constellation diagram only for the certain time instance, and if the rotation of the constellation diagram does not prevail for the next further time instances, then this leads to false derived data values for the certain time instance and also for that single next time instance that succeeds the certain time instance.

Hence, the signal received after carrier recovery may be affected by phase slips, with a probability depending on the non-linear phase noise introduced by the optical transmission link. If the phase slip is not recovered, error propagation will occur at the receiver and all data following the phase slip may not be properly corrected by a Forward Error Correction (FEC) decoder. Details on iterative decoding of a FEC code and a differential code can be found in M. Franceschini, G. Ferrari, R. Raheli, A. Curtoni, "Serial concatenation of LDPC codes and differential modulations," IEEE Trans. Commun., vol. 23, no. 9, pp. 1758-1768, Sept. 2005.

The random phase slips on the channel can be taken into account by an appropriately chosen clipping function (S-Function), which is inserted in the iterative loop between differential decoder and FEC decoder, cf. EP11305776. The advantage of this solution is that a standard differential decoder with soft-output decoding can be utilized. Such a decoder is commonly based on the trellis representation using the MAP/BCJR algorithm, cf. e.g. L. R. Bahl, J. Cocke, F. Jelinek, and J. Raviv, "Optimal Decoding of Linear Codes for minimizing symbol error rate", IEEE Transactions on Information Theory, vol. IT-20(2), pp.284-287, March 1974. A drawback of this solution may be that the Very Large Scale Integration (VLSI) implementation may be complicated due to the presence of two different decoding domains. E.g., the FEC Low Density Parity Check (LDPC) Code is decoded based on a Tanner graph, performing iteratively variable node and check node operations while the differential code operates based on a trellis diagram requiring a forward and a backward recursion over the diagram. As there is no direct mapping between both domains, memory and conversion is used in the VLSI implementation, limiting the implementable amount of iterations. Furthermore, the publication by Jianrong Bao et al.: "Concatenated eIRA Codes for Tamed Frequency Modulation", IEEE International Conference on Communications, ICC'08, 19 - 23 May 2008, Beijing, China, pages 1886-1891, discloses a deep space communications receiver for jointly decoding an eIRA code and a differential code which is part of a tamed frequency modulation scheme. Joint decoding includes alternating between message passing iterations performed on two portions of a Tanner graph respectively representing the eIRA coding constraint and the differential coding constraint.

Summary

Embodiments are based on the finding that the role of the differential code can be reinterpreted and considered as part of the overall FEC scheme. The differential decoder may not be implemented as such but integrated into a Tanner graph representation of the FEC code, e.g. a LDPC code. Embodiments may provide the advantage that only a single domain may be used for executing a decoding algorithm. The decoding algorithm may be a joint algorithm integrating the differential decoding into FEC decoding. Embodiments may provide better possibilities for exploiting parallelization at a VLSI decoder.

Embodiments may provide an apparatus operable to decode a received codeword derived from an optical signal, the codeword comprising samples of QPSK modulated symbols. In other words, a received codeword can be decoded by the apparatus. The apparatus may comprise means for decoding the codeword, such as a decoder, a processor, a digital signal processor, etc. The codeword itself can be received using an optical signal, which is then converted into an electrical signal, e.g. in a CN of a communication system or in a packet data network in general. The electrical signal can then be processed or converted into a time discrete or quantized representation. In some embodiments the received codeword corresponds to a digital base band representation of an optical receive signal.

The received codeword is based on a transmit codeword, which is encoded by a FEC encoding rule and a differential encoding rule. The differential encoding rule can be subsequent to the FEC encoding rule. That is to say, a digital information word may be encoded by a FEC code and by a differential code before being further processed. The further processing may include converting the codeword from a digital representation in the base band to an analogue representation in a transmission band and a conversion from an electrical representation into an optical representation before being transmitted. The received codeword may comprise samples of phase modulated symbols of the transmitted codeword.

Moreover, the apparatus is operable to decode the received codeword based on a joint decoding scheme. The joint decoding scheme is based on a combination of a differential decoding rule associated to the differential encoding rule and a FEC decoding rule associated to the FEC encoding rule such that differential decoding is integrated into FEC decoding. the apparatus comprises means for mapping complex symbols from the QPSK demodulator onto finite ring Z4, non-binary Z4 variable nodes and non-binary check-nodes for applying the differential decoding rule, wherein the output of the mapping means is connected to said non-binary Z4 variable nodes, and means for converting information output by said non-binary check nodes to binary LLRs for use in binary variable nodes of the forward error correction decoding rule. The word "joint" shall indicate that rather than iterating or alternating between a differential and an FEC decoder, embodiments use a decoding rule in which both decoders can be processed jointly or together. Embodiments may provide the advantage that an iteration or alternation between two decoders can be circumvented and an iteration of a single joint decoder can be used, which can simplify or compact the implementation.

Embodiments also provide an apparatus for decoding a received codeword in an optical network device. That is to say, the apparatus can be used, implemented or included in the optical device, where the optical device may comprise further components such as means to convert an optical signal into an electrical signal such as an optical/electrical converter. Moreover, the optical device can be operable to convert the electrical signal into a digital base band representation to obtain the received codeword. The apparatus may then be operable to decode the received codeword in a digital baseband representation. Hence, the received codeword is based on a transmit codeword, which is encoded by the FEC encoding rule and the differential encoding rule. The apparatus is operable to decode the received codeword based on the joint decoding scheme, which is based on a combination of the differential decoding rule and the FEC decoding rule such that differential decoding is integrated into FEC decoding. Thus, the apparatus may be implemented as an Integrated Circuit (IC) or a decoder chip suitable for use in such an optical device.

In embodiments the received codeword may comprise a plurality of samples, which may be obtained through conversion of a received signal from a transmission band to a base band and by digitizing the base band representation. In some embodiments the codeword may be a binary representation of a complex base band signal. The differential decoding rule may then be performed using a linear combination of the samples of the received codeword. In other words, in embodiments, both the differential decoding and the FEC decoding may be performed using a linear operations. The differential decoding rule and the FEC decoding rule may be combined to a common decoding rule, which is used in the joint decoding scheme or a joint linear combination. In some embodiments, the common decoding rule may be realized through a common linear combination of the samples of the received codeword, as will be detailed further subsequently.

The apparatus may be operable to carry out the joint decoding scheme based on a number of iterations. The apparatus may decode the received codeword by using a soft information representation of a decoded codeword. The soft information representation may correspond to an estimated decoded symbol or digit of the received codeword and reliability information on the estimated symbol or digit, such as a likelihood or a log-likelihood ratio. The soft information representation may then be modified in multiple iterations, as throughout the iterations the estimation and/or the reliability information thereon may change. Moreover, in embodiments in each of the iterations the combination of the differential decoding rule and the forward error correction decoding rule may be carried out.

Hence, in some embodiments each iteration can be based on a linear combination such as a matrix operation of a combined parity check matrix and the received codeword. That is to say, the combined parity check matrix may comprise a parity check part, which is based on the FEC decoding rule, and a differential decoding part, which is based on the differential decoding rule. Hence, the differential decoding rule may be expressed as a linear combination of the samples of the received codeword and the linear combination can be expressed as part of a matrix operation on the samples of the codeword.

For some embodiments, the joint decoding scheme can be modeled using a graph representation, e.g. a Tanner graph representation, which comprises different categories of nodes, which are represented by corresponding values. In embodiments the values may then be determined and updated in the iterations. In some embodiments the apparatus is operable to determine in each iteration a number of variable values. The number of variable values may correspond to a sum of a number of symbols in the received codeword and a number of binary values represented by the number of symbols in the received codeword. That is to say, there can be one variable value per symbol in the received codeword and one variable value per binary value represented by the symbols of the received codeword. One symbol in the received codeword may represent multiple binary values, e.g. a BPSK-symbol may represent one bit, a QPSK may represent 2 bits, a 16 QAM symbol may represent 4 bits, a 64QAM symbol may represent 6 bits, etc.

Moreover, the apparatus may be operable to determine in each iteration step a number of check values. The number of check values may correspond to a sum of the number of symbols in the received codeword and a number of parity bits introduced for the number of binary values by the FEC encoding rule. Hence, there may be one check value per symbol in the received codeword and one check value per parity bit of the FEC decoding rule. The variable values and the check values may correspond to information indicative of a transmit symbol and the variable values and the check values may be updated in each iteration. The information indicative of a transmit symbol may correspond to the above described soft information, e.g. to log-likelihood ratios.

In embodiments, the variable values and the check values can be associated by the joint decoding scheme and they may influence each other in each iteration. Hence, the variable values may be updated based on associated check values of a previous iteration and the check values may be updated based on associated variable values of the previous iteration. In embodiments the updates, i.e. the specific calculation rule or update process, depend on the joint decoding scheme and the FEC code. In general the variable and check values may correspond to soft information, which can be combined using mathematical formulas or relations.

In some embodiments a check value can be updated using the Jacobian logarithm of associated variable values. Correspondingly, a variable value may be updated using a Jacobian logarithm of associated check values. The Jacobian logarithm may be defined by

$$\text{Jac}(x, y) = \ln(e^x + e^y)$$

and in some embodiments it may be approximated by
$\text{Jac}(x, y) \cong \max(x, y)$. In some embodiments the Jacobian logarithm may be approximated by

$$\text{Jac}(x, y) = \ln\left(2\cosh\left(\frac{x}{2} - \frac{y}{2}\right)\right) + K(x, y) \cong \left|\frac{x}{2} - \frac{y}{2}\right| + K(x, y),$$

with

$$K(x, y) = \frac{x}{2} + \frac{y}{2}$$

wherein x and y are real numbers, which are based on the information indicative of the transmit symbol.

In some embodiments the number of iterations can be determined by a parity criterion, which is based on a combined parity check matrix operation. For example, a parity check matrix may be multiplied with an estimated decoded codeword and the result, e.g. when a zero-vector results, may indicate whether a valid codeword has been estimated. As it has already been described above, the combined parity check matrix may comprise a parity check part, which is based on the FEC decoding rule, and a differential decoding part, which is based on the differential decoding rule.

In some embodiments the implementation of embodiments may be further facilitated by subdividing the differential decoding part within the joint decoding scheme in parallel decoding branches. The differential decoding rule may then correspond to a plurality of parallel decoders in the joint decoding scheme. This may provide the advantage that the parallel decoders can be implemented independently from each other. Such a subdivision may in particular be possible based on a combined parity check matrix, which can be modified by row and column linear operations such that regions within the matrix can be made independent. Moreover, in some embodiments the apparatus may be operable to carry out the joint decoding scheme based on a number of iterations, wherein in at least one iteration only a subset of the parallel decoders is updated.

In embodiments, the FEC decoding rule can be based on a LDPC code, a turbo code, or a convolutional code. A detailed description for deriving information data values from likelihood values using a LDPC code can, for example, be found in "Frank R. Kschischang, Brendan J. Frey, Hans-Andrea Loeliger,'Factor graphs and the sum-product algorithm', IEEE TRANSACTIONS ON INFORMATION THEORY, VOL. 47, NO. 2, FEBRUARY 2001". A second alternative of an FEC code is a Turbo Code. A detailed description for deriving information data values from likelihood values using a Turbo code can, for example, be found in "J. Hagenauer, E. Offer, L. Papke, 'Iterative Decoding of Binary Block and Convolutional Codes', IEEE TRANSACTIONS ON INFORMATION THEORY, Vol.42, No.2, March1996 ". A detailed description for deriving information data values from likelihood values using a convolutional code can, for example, be found in "S. Benedetto, D. Divsalar, G. Montorsi, F. Pollara, 'A Soft-Input Soft-Output APP Module for Iterative Decoding of Concatenated Codes', IEEE COMMUNICATIONS LETTERS, VOL. 1, NO. 1, January 1997".

Embodiments further provide an optical network device for an optical communication system comprising the above described apparatus. The optical network device may correspond to an optical receiver, decoder, or transmission system comprising the above described apparatus.

Embodiments further provide a method for decoding a received codeword derived from an optical signal, the codeword comprising samples of QPSK modulated symbols. The received codeword is based on a transmit codeword, which is encoded by a forward error correction encoding rule and a differential encoding rule. The method comprises decoding the received codeword based on a joint decoding scheme. The joint decoding scheme is based on a combination of a differential decoding rule associated to the differential encoding rule and a forward error correction decoding rule associated to the forward error correction encoding rule such that differential decoding is integrated into forward error correction decoding. The method further comprises mapping complex symbols from the QPSK demodulator onto finite ring Z4 using non-binary Z4 variable nodes, applying the differential decoding rule at non-binary Z4 variable nodes and non-binary check-nodes, and converting information output by said non-binary check nodes to binary LLRs for use in binary variable nodes of the forward error correction decoding rule Embodiments further provide a computer program having a program code for performing one of the above methods, when the computer program is executed on a computer or processor.

Brief description of the Figures

Some other features or aspects will be described using the following non-limiting embodiments of apparatuses and/or methods and/or computer programs by way of example only, and with reference to the accompanying figures, in which

Fig. 1 shows a system overview with an embodiment;

Fig. 2 illustrates an embodiment of a joint decoder for BPSK modulation;

Fig. 3 illustrates another embodiment of a joint decoder with clipping for BPSK modulation;

Fig. 4 depicts a QPSK decoder;

Fig. 5 depicts an embodiment if a joint decoder with clipping for QPSK;

Fig. 6 shows an implementation of an update calculation in an embodiment;

Fig. 7 shows another implementation of an update calculation in an embodiment;

Fig. 8 shows yet another implementation of an update calculation in an embodiment;

Fig. 9 illustrates an approximation used in an embodiment;

Fig. 10 depicts a constellation diagram illustrating differential coding in an embodiment for 16QAM;

Fig. 11 illustrates a step of an iteration in an embodiment;

Fig. 12 illustrates an update step of an iteration in an embodiment;

Fig. 13 illustrates another step of an iteration in an embodiment;

Fig. 14 illustrates another update step of an iteration in an embodiment;

Fig. 15 illustrates another step of an iteration in an embodiment;

Fig. 16 illustrates another step of an iteration in an embodiment;

Fig. 17 illustrates an overview of an iteration in an embodiment;

Fig. 18 shows a layered decoder implementation of an embodiment;

Fig. 19 illustrates a computing element for use in row decoding using marginalization approximation in an embodiment;

Fig. 20 depicts replacing an LDPC code by a Low-Density Generator Matrix (LDGM) code followed by a differential encoder in an embodiment;

Fig. 21 shows a reinterpretation of the non-systematic irregular repeat accumulate code followed by a differential encoder as an LDPC code with punctured variable nodes in an embodiment;

Fig. 22 illustrates including S-function within check node operation to prevent cycle slip effects in an embodiment using BPSK;

Fig. 23 illustrates including S-function within check node operation to prevent cycle slip effects in an embodiment using QPSK; and

Fig. 24 shows a flow chart of an embodiment of a method for decoding.

Description of some Embodiments

Various embodiments will now be described in more detail with reference to the accompanying drawings. In the figures, the thicknesses of lines, layers and/or regions may be exaggerated for clarity.

Accordingly, while embodiments are capable of various modifications and alternative forms, embodiments thereof are shown by way of example in the figures and will herein be described in detail. It should be understood, however, that there is no intent to limit embodiments to the particular forms disclosed, but on the contrary, embodiments are to cover all modifications, equivalents, and alternatives falling within the scope of the claims. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

In the following description some components will be displayed in multiple figures carrying the same reference signs, but may not be described multiple times in detail. A detailed description of a component may then apply to that component for all its occurrences.

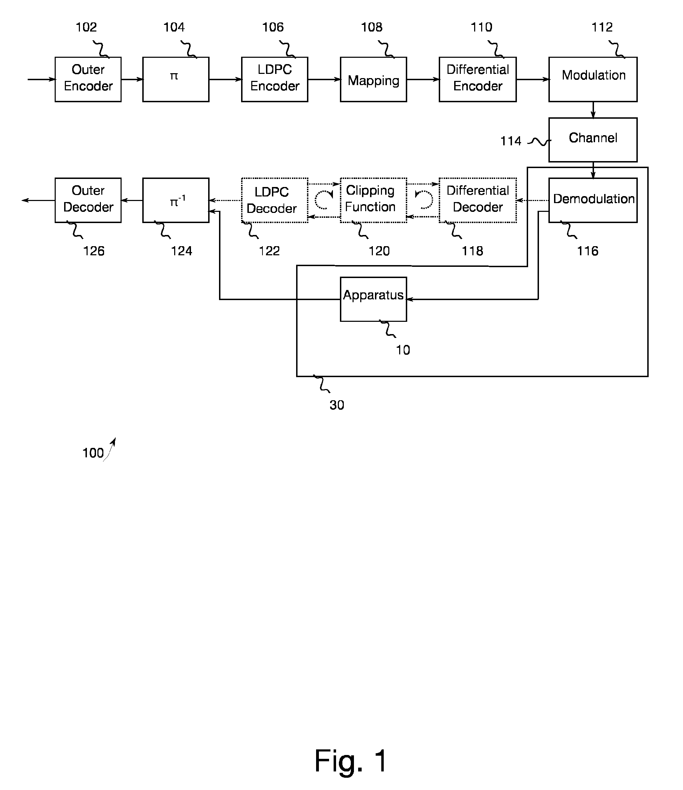

Fig. 1 illustrates a system overview, which will be used subsequently to further detail and explain some embodiments. Fig. 1 shows a signal processing chain of a communication system 100, e.g. an optical communication system, which can also be provided by an embodiment. The signal processing starts at the upper left corner of Fig. 1 with an outer encoder 102, which may, for example, correspond to a convolutional encoder or a Reed Solomon encoder 102. The task of the outer encoder 102 is to add redundancy to an input information word, which may comprise digitized data. The output of the outer encoder 102 is then input into an interleaver 104, which interleaves the data. The interleaving can be adapted to an error characteristic, which is introduced in the transmission channel 114 later on such that bundle errors can be resolved by subsequent de-interleaving 124 to enable enhanced error correction at an outer decoder 126. In the example of the communication system 100 the interleaved data is then input into an LDPC encoder 106 before being assigned to transmission symbols by mapping entity 108. The transmission symbols are differentially encoded by the differential encoder 110 to prevent or limit the effect of phase slips, which may occur in the subsequent transmission channel 114. The differentially encoded transmission symbols are then modulated by modulator 112 and transmitted through the transmission channel 114.

The modulation 112 may comprise a conversion from a base band, which can be complex, to a transmission band as well as a conversion from an electrical to an optical signal. In the present example an optical conversion and thus an optical transmission channel 114 is assumed. In a transmission channel, e.g. an optical, a wireless, a wireline or a powerline transmission channel, phase slips can occur due to the inability of the receiver to handle large phase noise, i.e. the phase may jump or suddenly change by a certain angle. This angle may correspond to 180° or $\pi$ in a BPSK case; it may correspond predominantly to 90° or $\pi/2$ in the QPSK case. Such a phase slip may result in erroneous symbols being detected subsequently. The differential coding limits the effect of a phase slip to the symbol, which is detected subsequent to the phase slip, as the difference to the previous symbol only is affected by the phase slip. However, since the difference to the next symbol is not affected by the phase slip (assuming only a single phase slip to occur), the differential encoding limits the effect of a phase slip.

The received codeword is demodulated 116, where the demodulation 116 may include optical/electrical conversion and conversion from the transmission band to the complex base band. Fig. 1 illustrates two processing paths between the demodulation 116 and the subsequent de-interleaver 124. One path follows the conventional processing, which is shown using dotted lines and involves differential decoder 118, a clipping function 120 and an LDPC decoder 122. The other path, which is shown in solid lines, uses an embodiment of an apparatus 10 for decoding a received codeword, which will be detailed subsequently.

Following the conventional path, the base band symbols are differentially decoded 118, which may result in soft information, i.e. information on estimated symbols or bits and reliability information thereon, which can, for example, be expressed in terms of likelihood values or log-likelihood values. In the example shown in Fig. 1 a clipping function 120 is applied to the output of the differential encoder. The clipping function 120 limits the likelihood values to enable a better decoding performance of the subsequent LDPC decoder 122. The performance of the LDPC decoder 122 can be improved by the limitation since an upper limit of the likelihood values can be assumed based on a known occurrence or probability of occurrence of a phase slip. For example, the probability of a phase slip for a given optical channel may be $10^{-3}$. Hence, all likelihood values can be limited to $(1-10^{-3})$ since this is the highest certainty that can be achieved. In other words, a residual error rate of $10^{-3}$ is known and considered by using an according the clipping function 120.

The clipped output of the clipping function 120 is then input into the LDPC decoder 122. The LDPC decoder 122 may then determine updated likelihood values, which are fed back to the clipping function 120 and from there to the differential decoder 118, which is indicated by the arrows between the differential decoder 118, the clipping function 120, and the LDPC decoder 122. The circular shaped arrows indicate that a number of iterations may be carried out, wherein the likelihood values are updated by one of the decoders 118, 122 and clipped in between by the clipping function 120. The iteration may be terminated by a parity check criterion, which will be explained in more detail subsequently. The output from the LDPC decoder 122 is then de-interleaved by de-interleaver 124 before being provided to the outer decoder 126 for outer decoding in line with the above described outer encoding 102.

According to the embodiment, the output of the demodulation 116 may correspond to a received codeword, which is input into an apparatus 10 for decoding the received codeword. The apparatus 10 may be implemented in an optical network device together with the demodulation 116. The apparatus may be operable to decode a received codeword derived from an optical signal, the codeword comprising samples of QPSK modulated symbols. The received codeword is based on a transmit codeword, which is encoded by a forward error correction encoding rule, which corresponds to LDPC encoder 106 in the present embodiment, and a differential encoding rule, which corresponds to the differential encoder 110 in the present embodiment.

The apparatus 10 is operable to decode the received codeword based on a joint decoding scheme. The joint decoding scheme is based on a combination of a differential decoding rule associated to the differential encoding rule and a forward error correction decoding rule associated to the forward error correction encoding rule such that differential decoding is integrated into forward error correction decoding. As it has already been mentioned above, the forward error correction decoding rule is based on a LDPC code in the present embodiment. In other embodiments a turbo code or a convolutional code is also conceivable. The apparatus 10 further comprises means for mapping complex symbols from the QPSK demodulator onto finite ring Z4, non-binary Z4 variable nodes and non-binary check-nodes for applying the differential decoding rule, wherein the output of the mapping means is connected to said non-binary Z4 variable nodes, and means for converting information output by said non-binary check nodes to binary LLRs for use in binary variable nodes of the forward error correction decoding rule.

Furthermore, in the embodiment the received codeword comprises samples of phase modulated symbols of the transmitted codeword.

Fig. 1 also illustrates an embodiment of an optical network device 30 for an optical communication system 100 comprising an embodiment of the apparatus 10. The optical network device 30 may correspond to a receiver 30 for the optical communication system 100 comprising the above apparatus 10 together with the demodulation means 116, which can correspond to a demodulator.

In the following two sets of embodiments will be described in detail. The first set of embodiments will refer to BPSK modulated symbols in the transmit codeword such that BPSK modulated samples are comprised in the received codeword. The second set of embodiments will refer to QPSK modulated symbols in the transmit codeword such that QPSK modulated samples are comprised in the received codeword. The BPSK embodiment will be considered first.

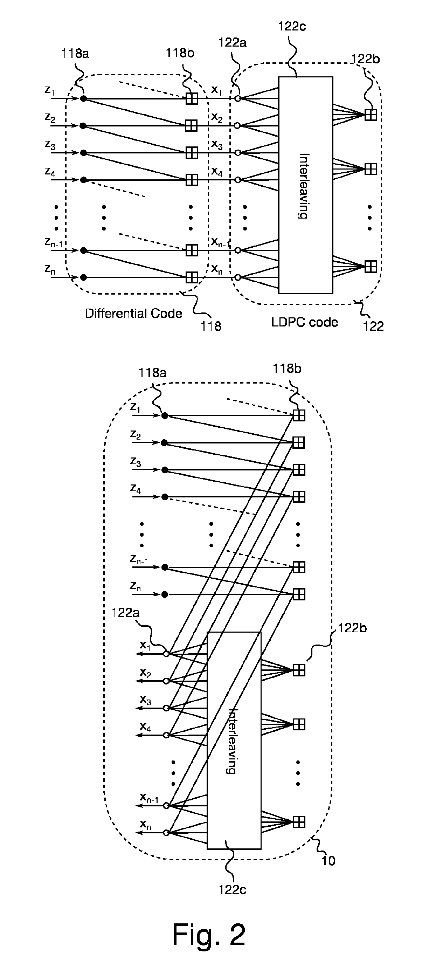

In the BPSK case, the differential encoder can be represented as a simple accumulator computing $y_i = y_{i-1} \oplus x_i$, where "$\oplus$" denotes the modulo-2 addition or the eXclusive OR (XOR) operation, respectively, which will also be symbolized by ⊞ in the following figures. Fig. 2 illustrates the conventional code interpretation of differential decoding 118 and LDPC decoding 122 at the top, where the clipping function 120 is neglected for simplicity reasons. The upper part of Fig. 2 shows the conventional concatenation of the differential code 118 and the LDPC code 122. The differential code 118 in the BPSK case can be represented by a factor graph consisting of variable nodes 118a (solid circles on the left) representing repetition of bits and check nodes 118b (indicated as XOR entities on the right) representing a single parity check node. Note that for simplicity reasons only a single variable node 118a and a single check node 118b are referenced in Fig. 2. As can be seen from the input values $z_1$-$z_n$ and the according number of $n$ branches, there are $n$ variable nodes and $n$ check nodes in the differential decoder 118.

The LDPC code 122 can be represented in a similar graph structure with variable nodes 122a on the left (non-solid circles), check nodes 122b on the right (XOR entities), and optimized interleaving 122c between the two classes of nodes in the middle. Again, it can be seen from Fig. 122a that there are $n$ variable nodes 122a for the values $x_1$-$x_n$ at the LDPC decoder 122. The number of check nodes 122b depends on the number of parity bits introduced by the LDPC code itself, and it may amount to $n$-$k$, with $k$ being the number of information bits.

The dashed line going to the check node connected to $z_l$ and $x_l$ is a possible termination or tailbiting connection, i.e. it may connect the first check node of the current codeword. The termination on the code at this check node may be a common termination independent on the first symbol of the block. If the code does not start in a defined state, i.e. it is left open, this connection can be discarded, and otherwise it can be used to initialize the code with a respective initialization state or value. Redrawing the upper part of Fig. 2 by placing the LDPC code 122 below the differential detector 118 gives the Tanner graph shown at the bottom part of Fig. 2 in line with an embodiment of apparatus 10. The graph consists of a total number of $2n$ variable nodes, where the first $n$ ($z_1$-$z_n$) of these are connected to the channel output while the other $n$ variable nodes ($x_1$-$x_n$) can be considered as punctured, i.e., there is no channel input. Besides the variable node, the graph consists of $n$+$n$-$k$=$2n$-$k$ check nodes, where $n$ of these are of degree 3, which means that the implementational complexity is kept low. The graph at the bottom of Fig. 2 shows how the differential code 118 is integrated into the LDPC code 120 (FEC) to form the joint decoding scheme of the apparatus 10.

For example, the original LDPC code is based on a parity check matrix H, i.e. the reinterpreted overall extended code or joint decoding scheme can also be expressed using a combined parity check matrix

$$
\mathbf{H'} = \left(
\begin{array}{ccccc|ccccc}
1 & & & & (1) & 1 & & & & \\
1 & 1 & & & & & 1 & & & \\
& 1 & \ddots & & & & & 1 & & \\
& & \ddots & 1 & & & & & 1 & \\
& & & 1 & 1 & & & & & 1 \\
\hline
\multicolumn{5}{c|}{\mathbf{0}} & \multicolumn{5}{c}{\mathbf{H}}
\end{array}
\right)
$$

or more generally

$$
\mathbf{H'} = \left(
\begin{array}{ccccc|c}
1 & & & & (1) & \\
1 & 1 & & & & \\
& 1 & \ddots & & & \mathbf{P} \\
& & \ddots & 1 & & \\
& & & 1 & 1 & \\
\hline
\multicolumn{5}{c|}{\mathbf{0}} & \mathbf{H}
\end{array}
\right)
$$

with **P** being a permutation matrix corresponding to an interleaver, which can in some embodiments be used between LDPC code 106 and modulator 112, and after the demodulator 116, respectively. Hence, the differential decoding rule is performed using a linear combination of the samples of the received codeword, and the differential decoding rule and the FEC decoding rule are combined to a common decoding rule, which is used in the joint decoding scheme. That is to say, the differential decoding rule is converted into a linear combination, as it can also be seen from the above matrix rows each having three values of "1", while the rest of its entries have a value of "0". Two of the three "1"-values in a row indicate the corresponding two samples between which the difference is determined and the third "1"-value of the row, which lies in the **P** matrix part, determines to which variable node of the LDPC code said difference is mapped.

As has already been mentioned above, the values of the samples of the received word can be represented by soft information and the concatenated code can be run in iterations. Hence, the joint decoding scheme represented at the bottom of Fig. 2 can be based on a number of iterations, wherein in each of the iterations the combination of the differential decoding rule and the forward error correction decoding rule in line with the given graph interpretation is carried out. Each of the iterations is based on a matrix operation of the combined parity check matrix **H'** and the received codeword. The combined parity check matrix **H'** comprises a parity check part **H**, which is based on the LDPC code, and a differential decoding part, which is based on the differential decoding rule. In the above general expression for **H'** it can be seen that the upper half of rows is determined by the differential code and the lower half of rows is determined by the LDPC code. In the embodiment the number of iterations can be determined by a parity criterion, which is based on the combined parity check matrix operation. E.g. the parity check part **H** can be used to determine whether a valid codeword has been found and the iteration can be terminated in this case. In some embodiments a parity check can be carried out by multiplying **H** with an estimated codeword and if a zero-vector is obtained, the estimated codeword can be considered as valid.

The matrix **H'** can be used with an LDPC decoder to jointly decode the differential BPSK code and the LDPC code in a fully parallel manner without requiring the utilization of a trellis, memory and retiming in between. That is to say, the differential decoding rule may correspond to a plurality of parallel decoders in the joint decoding scheme. Each column of the matrix **H'** corresponds to a variable node with the left *n* variable nodes being connected to the channel/demodulator output and the other *n* variable nodes being punctured.

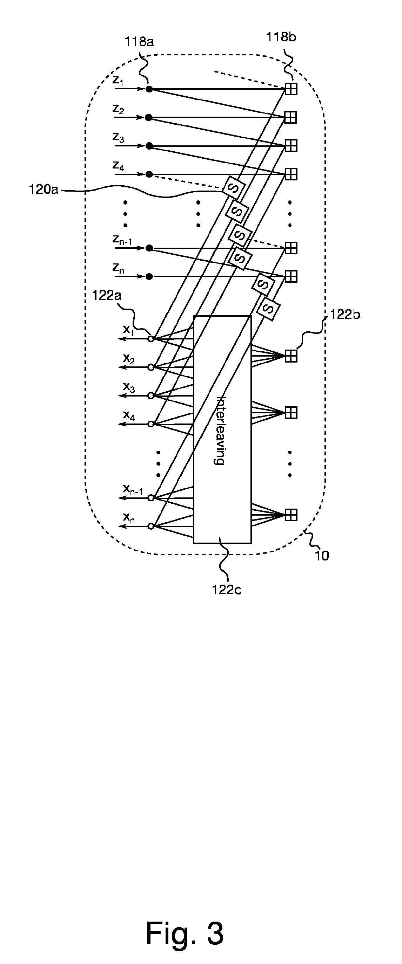

If phase slips occur, these can be controlled by placing clipping functions 120a at the connections between the connections from the upper *n* check nodes to the punctured variable nodes as described by Razetti, Costantini, Pepe, Leven, ten Brink, Schmalen in EP11305776. This is depicted in Fig. 3. Fig. 3 depicts the same graph interpretation of the joint decoding scheme as Fig. 2. In addition Fig. 3 shows clipping functions "S", of which only one is referenced by 120a. As can be seen from Fig. 3 there can be a clipping function in any branch connecting the check nodes 118b of the differential code part with the variable nodes 122a of the LDPC part. It should be stressed, however, that the clipping function (S-function) is not required in all cases or embodiments. Especially if the variable node degree is larger or equal than 3, i.e. the (punctured) variable nodes 122a of the original LDPC code has three or more connections to the LDPC check nodes 122b, then the effects of a phase slip may be compensated by the other connections. However, as codes with good convergence thresholds may require variable nodes of degree 2 or even 1, the clipping (S-)function may be needed in these cases.

In some embodiments, this representation may further facilitate the search for good LDPC codes using known methods to analyze the overall LDPC decoding structure. For example, density evolution or EXIT charts can be employed to find good candidates for **H**. A further advantage of embodiments using this representation may be that the new matrix **H'** comprises the differential decoding structure and the code design can therefore already incorporate the differential decoding, thus facilitating the code design procedure. Furthermore, the VLSI implementation may be largely simplified as a single row or layered decoder can operate on the matrix **H'**, thus avoiding the switching or alternating between differential decoder and LDPC decoder. An example of a single row decoder will be detailed subsequently.

In order to further facilitate parallelization in some embodiments, the upper left part of **H'** can also be decomposed into several blocks, which are not interconnected, for example

$$\mathbf{H'} = \begin{pmatrix} 1 & & & & & & & & 1 & & & & & & & \\ 1 & 1 & & & & & & & & 1 & & & & & & \\ & 1 & \ddots & & & & & & & & 1 & & & & & \\ & & \ddots & 1 & & & & & & & & 1 & & & & \\ & & & 1 & 1 & & & & & & & & 1 & & & \\ \hline & & & & & 1 & & & & & & & & 1 & & \\ & & & & & 1 & 1 & & & & & & & & 1 & \\ & & & & & & 1 & \ddots & & & & & & & & 1 \\ & & & & & & & \ddots & 1 & & & & & & & 1 \\ & & & & & & & & 1 & 1 & & & & & & 1 \\ \hline & & & \mathbf{0} & & & & & & & \mathbf{H} & & & & \end{pmatrix}.$$

This representation is favorable for hardware implementation as due to the missing interconnections, the different blocks can be computed independently in parallel. Hence, in such an embodiment a number of parallel decoders may be implemented.

Another representation of **H**' in an embodiment, which may be favorable for hardware implementation, is given an odd-even interleaving of the rows of the upper part:

$$\mathbf{H'} = \begin{pmatrix} 1 & & & & & & & & 1 & & & & & \\ & 1 & 1 & & & & & & & 1 & & & & \\ & & & 1 & 1 & & & & & & 1 & & & \\ & & & & 1 & 1 & & & & & & 1 & & \\ & & & & & \ddots & & \ddots & & & & & 1 & \\ 1 & 1 & & & & & & & 1 & & & & & \\ & & 1 & 1 & & & & & & & 1 & & & \\ & & & & 1 & 1 & & & & & & 1 & & \\ & & & & & 1 & & 1 & & & & & 1 & \\ & & & & & & \ddots & & \ddots & & & & & 1 \\ \hline & & & \mathbf{0} & & & & & & & \mathbf{H} & & \end{pmatrix}.$$

In embodiments this representation may be favorable if row decoding is used as both halves of the upper part of **H**' are completely independent and thus the decoding of both parts can be completely parallelized without conflicting memory accesses. In some embodiments the decoding complexity may be further reduced by switching-on or enabling only a fraction of the rows in the row decoder to perform some kind of "partial update" on the variable nodes according to some optimized schedule. That is to say, in some embodiments the apparatus 10 is operable to carry out the joint decoding scheme based on a number of iterations, wherein in at least one iteration only a subset of the parallel decoders is updated.

Further, note that although the number of check nodes may be increased compared to the original matrix **H**, these check nodes have a degree of only 3, thus their decoding is highly simplified compared to higher degree (d > 20) check nodes and also the memory requirements for keeping track of the extrinsic output are reduced.

In the following a second set of embodiments will be described in which the received codeword comprises samples of QPSK modulated symbols.

In embodiments processing QPSK modulated samples, the situation is more complicated as the QPSK differential encoder 110, cf. Fig. 1, cannot be described easily in binary representation. It is convenient to employ a finite ring $Z_4$ of integer numbers {0, 1, 2, 3}. Differential encoding corresponds to an accumulator operating on the ring $Z_4$. Addition on $Z_4$ is defined as addition modulo 4. The following table gives the differential encoding operation for QPSK, which can be used in embodiments:

| $x_i/y_{i-1}$ | 0 | 1 | 2 | 3 |
|---|---|---|---|---|
| 0 | 0 | 1 | 2 | 3 |
| 1 | 1 | 2 | 3 | 0 |
| 2 | 2 | 3 | 0 | 1 |
| 3 | 3 | 0 | 1 | 2 |

which can be written as $y_i \equiv y_{i-1} + x_i \bmod 4$. In order to operate with a binary code, a mapping from the binary numbers to the $Z_4$ values can be defined. Gray mapping ($00 \to [0]_4$, $01 \to [1]_4$, $11 \to [2]_4$, $10 \to [3]_4$, where $[u]_4$ emphasizes that u is an element of the ring $Z_4$, may, for example, be used in embodiments and it may facilitate the use of the clipping (S-)function to combat phase slips, cf. EP11305776. Furthermore, a mapping of the $Z_4$ values $y_i$ to the actual QPSK symbols is required. One possibility is to use the mapping according to ($[0]_4 \to 1+i$, $[1]_4 \to -1+i$, $[2]_4 \to -1-i$, $[3]_4 \to 1-i$). Furthermore, QPSK symbols are often given in power-normalized form with the QPSK symbols lying on the unit circle, i.e., the symbols are, e.g., $(1+i)/\sqrt{2}$, $(-1+i)/\sqrt{2}$, etc.

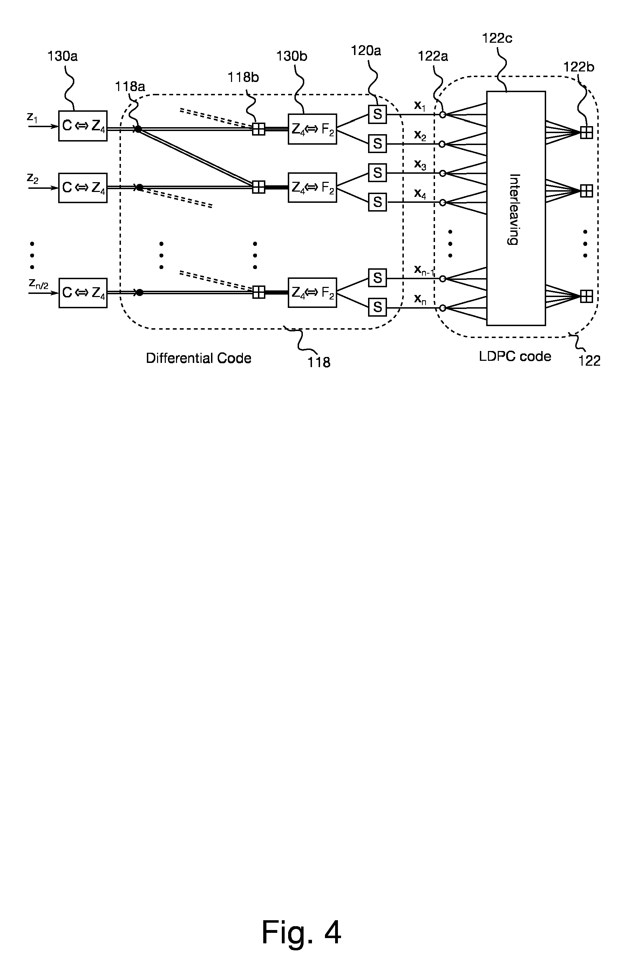

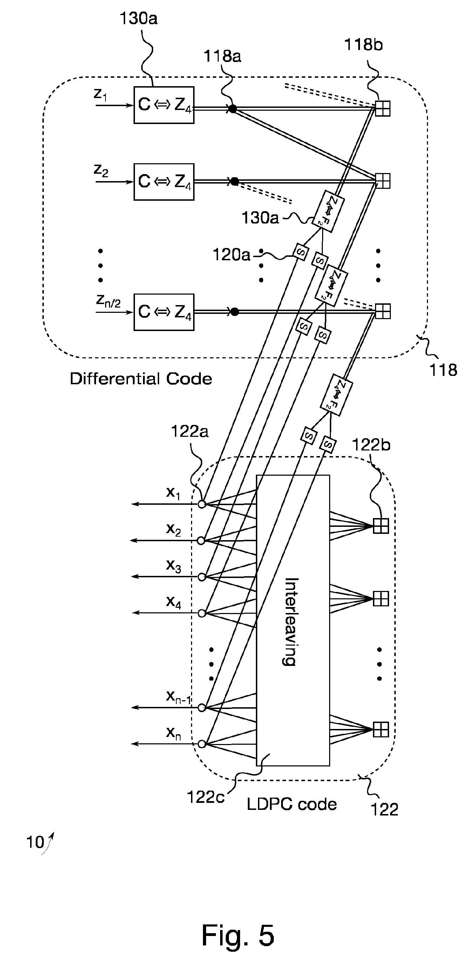

Fig. 4 shows a factor graph interpretation of the decoder in the QPSK conventional case. Fig. 5 illustrates an embodiment of the apparatus 10 in factor graph or Tanner graph interpretation with the joint decoding scheme. In line with the above description for the BPSK case, the differential decoding 118 is integrated into the LDPC coding 122 to form the joint decoding scheme. The complex symbols $z_1$-$z_n$ as input into the factor graph of the differential code 118 are mapped onto the above finite ring $Z_4$, which is indicated in Figs. 4 and 5 by the blocks 130a. For simplicity reasons only the mapping block 130a of the top branch is referenced in Figs. 4 and 5, as can be seen each branch comprises such a mapping block. Moreover, Figs. 4 and 5 show the clipping functions 120a which can optionally be operable in the branches connecting the check nodes 118b of the differential code 118 and the variable nodes 122a of the LDPC code 122.

The apparatus 10 can be operable to determine in each iteration a number of variable values 118a, 122a. The number of variable values 118a, 122a may correspond to a sum of a number of symbols in the received codeword and a number of binary values represented by the number of symbols in the received codeword. Comparing Fig. 3 for the BPSK case, where one symbol in the received codeword represents one bit, and Fig. 5 for the QPSK case, where one symbol in the received codeword represents two bits, it is to be noted that in Fig. 5, the graph of the differential decoder 118 consists of $n' = n/2$ variable nodes 118a and check nodes 118b.

Moreover, the apparatus 10 can be operable to determine a number of check values 118b, 122b. The number of check values corresponds to a sum of the number of symbols in the received codeword and a number of parity bits introduced for the number of binary values by the LDPC code 122.

In the present embodiment, the variable values and the check values correspond to information indicative of a transmit symbol. The variable values and the check values are updated in each iteration. Hence, prior to decoding, the received values are converted to log-likelihood ratios for numerical stability reasons. It is convenient to use an LLR vector of size 4 to represent the received values.

$$\mathbf{L}(z) = \begin{pmatrix} L_0(z) & L_1(z) & L_2(z) & L_3(z) \end{pmatrix}$$
$$= \left( \ln\left( \frac{p(z \mid y=[0]_4)}{p(z \mid y=[0]_4)} \right) \quad \ln\left( \frac{p(z \mid y=[1]_4)}{p(z \mid y=[0]_4)} \right) \quad \ln\left( \frac{p(z \mid y=[2]_4)}{p(z \mid y=[0]_4)} \right) \quad \ln\left( \frac{p(z \mid y=[3]_4)}{p(z \mid y=[0]_4)} \right) \right) \quad (1)$$
$$= \begin{pmatrix} 0 & -L_I & -L_I - L_Q & -L_Q \end{pmatrix}$$

with $L_I = 4E_s/N_0\, Re\{z\}$ and $L_Q = 4E_s/N_0\, Im\{z\}$ with $E_s/N_0$ denoting the signal-to-noise ratio on the channel, see, e.g., J. Hagenauer, E. Offer, L. Papke "Iterative Decoding of Binary Block and Convolutional Codes", IEEE Trans. Inform. Theory, vol. 42, no. 2, March 1996. If the QPSK symbols are on the unit circle, i.e., $(1+i)/\sqrt{2}$, then $L_I = 4E_s/N_0\sqrt{2}/2\, Re\{z\}$ and $L_Q = 4E_s/N_0\sqrt{2}/2\, Im\{z\}$, accordingly. A constant can be assumed to scale the LLR, especially, in an Application Specific Integrated Circuit (ASIC) implementation where $E_s/N_0$ may be estimated or not available.

As the first element of $L(z)$ is always zero, only 3 values are tracked and stored. The conversion equation is obtained by decomposing the QPSK into two BPSKs, e.g. real and imaginary axis. Exemplarily, the computation of $L_I(z)$ is shown:

$$\ln\left(\frac{p(z\mid y=[1]_4)}{p(z\mid y=[0]_4)}\right) = \ln\left(\frac{p(z\mid \mathrm{Re}\{y\}=-1 \wedge \mathrm{Im}\{y\}=+1)}{p(z\mid \mathrm{Re}\{y\}=+1 \wedge \mathrm{Im}\{y\}=+1)}\right)$$

$$= \ln\left(\frac{p(\mathrm{Re}\{z\}\mid \mathrm{Re}\{y\}=-1)\,p(\mathrm{Im}\{z\}\mid \mathrm{Im}\{z\}=+1)}{p(\mathrm{Re}\{z\}\mid \mathrm{Re}\{y\}=+1)\,p(\mathrm{Im}\{z\}\mid \mathrm{Im}\{z\}=+1)}\right)$$

$$= \ln\left(\frac{p(\mathrm{Re}\{z\}\mid \mathrm{Re}\{y\}=-1)}{p(\mathrm{Re}\{z\}\mid \mathrm{Re}\{y\}=+1)}\right)$$

$$= -\ln\left(\frac{p(\mathrm{Re}\{z\}\mid \mathrm{Re}\{y\}=+1)}{p(\mathrm{Re}\{z\}\mid \mathrm{Re}\{y\}=-1)}\right) = -4\frac{E_s}{N_0}\mathrm{Re}\{z\} = -L_I$$

It can be further shown that

$$p(z\mid y=[0]_4) = \frac{1}{1+e^{L_1(z)}+e^{L_2(z)}+e^{L_3(z)}} \quad \text{and} \quad p(z\mid y=[1]_4) = \frac{e^{L_1(z)}}{1+e^{L_1(z)}+e^{L_2(z)}+e^{L_3(z)}}$$

$$p(z\mid y=[2]_4) = \frac{e^{L_2(z)}}{1+e^{L_1(z)}+e^{L_2(z)}+e^{L_3(z)}} \quad \text{and} \quad p(z\mid y=[3]_4) = \frac{e^{L_3(z)}}{1+e^{L_1(z)}+e^{L_2(z)}+e^{L_3(z)}} .$$

The double lines in Figs. 4 and 5 indicate that non-binary values are used and that vectors ofLLRs (consisting of 3 entries each) are considered.

Similar as in the binary case, the operations at the non-binary $Z_4$ variable nodes consist of a simple addition, i.e., for example, the outgoing value from variable node connected to channel output $z_i$ connecting check node $c_i$ is thus given by $\mathbf{L}(z_i \leftarrow c_i) = \mathbf{L}(z_i) + \mathbf{L}(z_i \leftarrow c_{i+1})$, wherein i is a positive integer. Note that the three additions of the vector entries can be computed in parallel.

The computation at the check nodes is slightly more complicated and can best be explained by an example. Observe that

$$P(y_i = [2]_4)$$

$$= P\big((x_i = [0]_4 \wedge y_{i-1} = [2]_4) \vee (x_i = [1]_4 \wedge y_{i-1} = [1]_4) \vee (x_i = [2]_4 \wedge y_{i-1} = [0]_4) \vee (x_i = [3]_4 \wedge y_{i-1} = [3]_4)\big)$$

$$= P\big(x_i = [0]_4 \wedge y_{i-1} = [2]_4\big) + P\big(x_i = [1]_4 \wedge y_{i-1} = [1]_4\big) + P\big(x_i = [2]_4 \wedge y_{i-1} = [0]_4\big) + P\big(x_i = [3]_4 \wedge y_{i-1} = [3]_4\big)$$

$$= P(x_i = [0]_4)P(y_{i-1} = [2]_4) + P(x_i = [1]_4)P(y_{i-1} = [1]_4) + P(x_i = [2]_4)P(y_{i-1} = [0]_4) + P(x_i = [3]_4)P(y_{i-1} = [3]_4)$$

by assuming statistical independence of $x_i$ and $y_{i-1}$.

Using the above-mentioned relationships between pdfs and LLRs, after simplification and exploiting the fact that $L_0(x_i) = L_0(y_{i-1}) = 0$) it follows:

$$\widetilde{L}_2(y_i) = \ln\left(e^{L_2(y_{i-1})} + e^{L_1(x_i)+L_1(y_{i-1})} + e^{L_2(x_i)} + e^{L_3(x_i)+L_3(y_{i-1})}\right). \tag{2}$$

Similar expressions can be found for the other values and they are given by

$$\widetilde{L}_0(y_i) = \ln\left(1 + e^{L_1(x_i)+L_3(y_{i-1})} + e^{L_2(x_i)+L_2(y_{i-1})} + e^{L_3(x_i)+L_1(y_{i-1})}\right)$$

$$\widetilde{L}_1(y_i) = \ln\left(e^{L_1(y_{i-1})} + e^{L_1(x_i)} + e^{L_2(x_i)+L_3(y_{i-1})} + e^{L_3(x_i)+L_2(y_{i-1})}\right)$$

$$\widetilde{L}_3(y_i) = \ln\left(e^{L_3(y_{i-1})} + e^{L_1(x_i)+L_2(y_{i-1})} + e^{L_2(x_i)+L_1(y_{i-1})} + e^{L_3(x_i)}\right) \qquad (3)$$

Where $L(y_i)$ corresponds to the information emerging from the variable node connected to $z_i$, i.e., it corresponds to $L(z_i \rightarrow c_i)$. Note that this operation corresponds to the well-known and widely utilized Jacobian logarithm, which is defined as

$$\mathrm{Jac}(a,b) = \ln\left(e^a + e^b\right) = \max(a,b) + \underbrace{\ln\left(1 + e^{-|a-b|}\right)}_{\eta(a-b)} \approx \max(a,b)$$

and

$$\mathrm{Jac}(a,b,c) = \mathrm{Jac}(a,\mathrm{Jac}(b,c)) = \mathrm{Jac}(\mathrm{Jac}(a,b),c)$$

In other words, the variable values are updated based on associated check values of a previous iteration. The check values are updated based on associated variable values of the previous iteration. A check value is updated using a Jacobian logarithm of associated variable values and a variable value is updated using a Jacobian logarithm of associated check values.

Ignoring the correction term $\eta(a\text{-}b)$ leads to the known Max-log approximation. The term $\eta(a\text{-}b)$ can also be computed using a Look-Up Table (LUT). Normalization then leads to:

$$L_0(y_i) = 0$$

$$L_1(y_i) = \widetilde{L}_1(y_i) - \widetilde{L}_0(y_i)$$

$$L_2(y_i) = \widetilde{L}_2(y_i) - \widetilde{L}_0(y_i)$$

$$L_3(y_i) = \widetilde{L}_3(y_i) - \widetilde{L}_0(y_i)$$

Note that the processing of the four different values can be fully done in parallel and the 3 non-zero values can be stored and fed to the connected variable node (connected to the channel input $z_i$) for use in a subsequent iteration.

The computation of the other two check node outputs is slightly different, as the embodiment now is operating in $Z_4$. As $y_i = y_{i-1}+x_i$, it follows $y_{i-1} = y_i - x_i$ and $x_i = y_i - y_{i-1}$. Following the same reasoning as above, it can be computed, for instance,

$$P(y_{i-1} = [2]_4) = P(x_i = [0]_4)P(y_i = [2]_4)$$
$$+P(x_i = [1]_4)P(y_i = [3]_4)$$
$$+P(x_i = [2]_4)P(y_i = [0]_4)$$
$$+P(x_i = [3]_4)P(y_i = [1]_4)$$

leading to the equations in LLR domain:

$$\widetilde{L}_0(y_{i-1}) = \ln\left(1 + e^{L_1(x_i)+L_1(y_i)} + e^{L_2(x_i)+L_2(y_i)} + e^{L_3(x_i)+L_3(y_i)}\right)$$

$$\widetilde{L}_1(y_{i-1}) = \ln\left(e^{L_1(y_i)} + e^{L_1(x_i)+L_2(y_i)} + e^{L_2(x_i)+L_3(y_i)} + e^{L_3(x_i)}\right)$$

$$\widetilde{L}_2(y_{i-1}) = \ln\left(e^{L_2(y_i)} + e^{L_1(x_i)+L_3(y_i)} + e^{L_2(x_i)} + e^{L_3(x_i)+L_1(y_i)}\right)$$

$$\widetilde{L}_3(y_{i-1}) = \ln\left(e^{L_3(y_i)} + e^{L_1(x_i)} + e^{L_2(x_i)+L_1(y_i)} + e^{L_3(x_i)+L_2(y_i)}\right)$$

Although the equations look different from those above, the same module can be used. Negating $x_i$ at the input corresponds to swapping the elements $L_1(x_i)$ and $L_3(x_i)$, or respectively multiplying the check node vector $\mathbf{L}(x_i)$ by a permutation matrix

$$\mathbf{P} = \begin{pmatrix} 1 & 0 & 0 & 0 \\ 0 & 0 & 0 & 1 \\ 0 & 0 & 1 & 0 \\ 0 & 1 & 0 & 0 \end{pmatrix}.$$

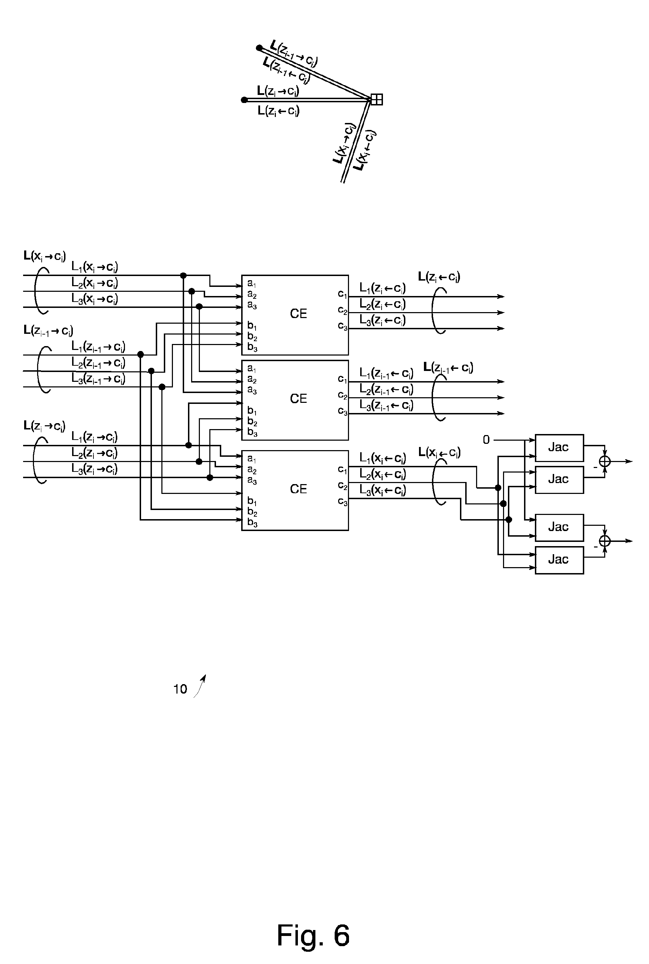

A detailed computation element of a check node of the embodiment is shown in Fig. 6, where each computational element (CE) performs the following operations

$$\widetilde{c}_0 = \mathrm{Jac}(0, a_1 + b_3, a_2 + b_2, a_3 + b_1)$$

$$c_1 = \mathrm{Jac}(b_1, a_1, a_2 + b_3, a_3 + b_2) - \widetilde{c}_0$$

$$c_2 = \mathrm{Jac}(b_2, a_1 + b_1, a_2, a_3 + b_3) - \widetilde{c}_0 .$$

$$c_3 = \mathrm{Jac}(b_3, a_1 + b_2, a_2 + b_1, a_3) - \widetilde{c}_0$$

Fig. 6 illustrates the computation and information flow at each non-binary check node in an embodiment of the apparatus 10. Fig. 6 shows an excerpt of a graph interpretation of a check node at the top and an implementation using three Computing Elements (CE) at bottom. As the arrows in Fig. 6 and in the following indicate a CE has six inputs ($a_1$, $a_2$, $a_3$, $b_1$, $b_2$, $b_3$) and three outputs ($c_1$, $c_2$, $c_3$). In the following figures inputs are shown on the left and outputs are shown on the right of the respective components. In the lower right corner the operations using the Jacobian logarithm are depicted by boxes labeled "Jac", each having two respective inputs on the left and an output on the right. Note that the permutation matrix **P** is already implicitly taken into account by the connections to the middle and bottom CE in Fig. 6. Actually some intermediate results in the different CEs can be used twice and need only be computed once.

In a final step, which is shown in the bottom right corner of Fig. 6, the information $\mathbf{L}(x_i \leftarrow c_i)$ needs to be converted to binary LLRs for use in the binary variable nodes of the LDPC code. This can be done based on the mapping, for instance, if a Gray mapping is used, it follows

$$L_{bin}^{(1)}(x_i) = \ln\left(\frac{P_{x_i \leftarrow c_i}(\text{bit } 1 = 0)}{P_{x_i \leftarrow c_i}(\text{bit } 1 = 1)}\right) = \ln\left(\frac{e^{L_0(x_i \leftarrow c_i)} + e^{L_1(x_i \leftarrow c_i)}}{e^{L_2(x_i \leftarrow c_i)} + e^{L_3(x_i \leftarrow c_i)}}\right)$$

$$= \text{Jac}(0, L_1(x_i \leftarrow c_i)) - \text{Jac}(L_2(x_i \leftarrow c_i), L_3(x_i \leftarrow c_i)),$$

$$L_{bin}^{(2)}(x_i) = \ln\left(\frac{P_{x_i \leftarrow c_i}(\text{bit } 2 = 0)}{P_{x_i \leftarrow c_i}(\text{bit } 2 = 1)}\right) = \ln\left(\frac{e^{L_0(x_i \leftarrow c_i)} + e^{L_3(x_i \leftarrow c_i)}}{e^{L_1(x_i \leftarrow c_i)} + e^{L_2(x_i \leftarrow c_i)}}\right)$$

$$= \text{Jac}(0, L_3(x_i \leftarrow c_i)) - \text{Jac}(L_1(x_i \leftarrow c_i), L_2(x_i \leftarrow c_i)),$$

where $L_{bin}^{(l)}$ is the first bit of the binary representation of the respective codeword.

The reverse direction works exactly in the same way as for the conversion of the channel-related LLRs and is given by (for the Gray mapping)

$$\mathbf{L}(x_i \rightarrow c_i) = \left(0 \quad -L_{bin}^{(2)}(x_i) \quad -L_{bin}^{(1)}(x_1) - L_{bin}^{(2)}(x_i) \quad -L_{bin}^{(1)}(x_1)\right). \tag{4}$$

The check node expressions are similar to those of the check node decoders of $GF(2^2)$ LDPC codes, cf. H. Wymeersch, H. Steendam, M. Moeneclaey, "Log-Domain Decoding of LDPC codes over GF(q)", IEEE Conf. on Communications (ICC), 2004. There are differences due to various underlying algebraic structures, i.e. $GF(2^2)$ is a field while $Z_4$ is only a ring.

In further embodiments a simplification of the computing element can be utilized, which will be described in the following. Using the exact computation, the messages passed between variable and check nodes are composed of three different values. The amount of messages passed over an edge connection in the graph representation can be reduced from 3 to 2 in some embodiments by performing a marginalization of the values, i.e. they are converted back to two pseudo-binary values before being passed back to the other computation node.

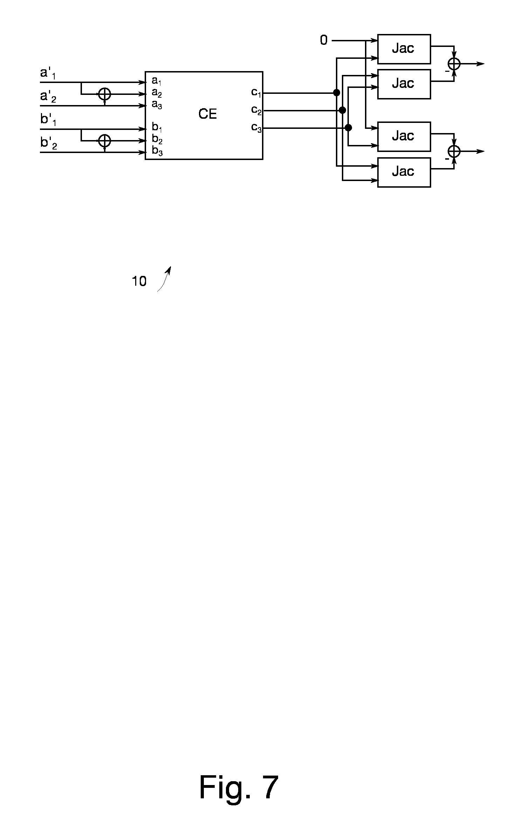

From equation (1) it can be seen, for example, that $L_2(z) = L_1(z) + L_3(z)$. Also, note that after each iteration the values passed from the binary LDPC code to the non-binary check nodes given in (4) are obtained by the same assumption. The resulting computation element is shown in Fig.7. Fig. 7 shows an excerpt of an implementation of the apparatus 10 in terms of a CE making use of the above simplification. The computations done within the CE can be simplified by exploiting the fact that $a_2 = a_1 + a_3$ and $b_2 = b_1 + b_3$. The resulting computation element CE' performs the operations

$$c_0 = \text{Jac}(0, a'_1 + b'_2) + \text{Jac}(0, a'_2 + b'_1) = \ln\left(4\cosh\left(\frac{a'_1}{2} + \frac{b'_2}{2}\right)\cosh\left(\frac{a'_2}{2} + \frac{b'_1}{2}\right)\right) + K$$

$$c_1 = \text{Jac}(a'_1, b'_1) + \text{Jac}(0, a'_2 + b'_2) = \ln\left(4\cosh\left(\frac{a'_1}{2} - \frac{b'_1}{2}\right)\cosh\left(\frac{a'_2}{2} + \frac{b'_2}{2}\right)\right) + K$$

$$c_2 = \mathrm{Jac}(a'_1, b'_2) + \mathrm{Jac}(a'_2, b'_1) = \ln\left(4\cosh\left(\frac{a'_1}{2} - \frac{b'_2}{2}\right)\cosh\left(\frac{a'_2}{2} - \frac{b'_1}{2}\right)\right) + K$$

$$c_3 = \mathrm{Jac}(a'_2, b'_2) + \mathrm{Jac}(0, a'_1 + b'_1) = \ln\left(4\cosh\left(\frac{a'_2}{2} - \frac{b'_2}{2}\right)\cosh\left(\frac{a'_1}{2} + \frac{b'_1}{2}\right)\right) + K \quad,$$

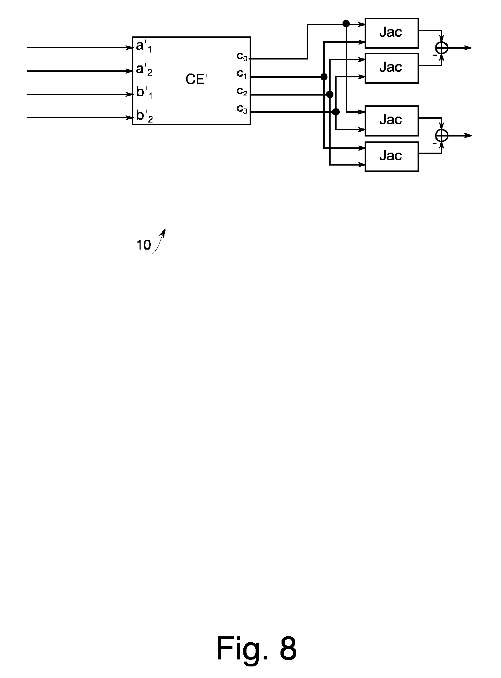

with $a_1'$ corresponding to the variable $a_1$ while $a_2'$ (and $b_2'$) correspond to $a_3$ (and $b_3$), and the resulting block diagram, or implementation excerpt of the apparatus 10, including the following conversion to pseudo-binary or marginalized values is shown in Fig. 8. In other words, Fig. 8 shows a simplified CE' of an embodiment if the approximation using marginalization is used. Furthermore, it is to be noted that the above $K$-value is not a real constant, but be dependent on the respective variables $a_1'$, $a_2'$, $b_1'$, $b_2'$. However, if the outputs are computed, i.e., $c_1$-$c_0$, $c_2$-$c_0$, $c_3$-$c_0$ are calculated, the value $K$ will cancel in all terms and may not appear in the output, such that it can be neglected in the present embodiment.

The subtraction in $Z_4$ (which is carried out for computing two out of the three check node outputs) can again be implemented by swapping the inputs $a_1'$ and $a_2'$ or $b_1'$ and $b_2'$, respectively, as these inputs are not affected by the marginalization approximation. These expressions can be simplified by approximating either

$$\mathrm{Jac}(x,y) \cong \max(x,y)$$

or

$$\log(2\cosh(x)) \cong |x|.$$

That is to say, in some embodiments the Jacobian logarithm can be approximated by

$$\mathrm{Jac}(x, y) = \ln(e^x + e^y) \cong \max(x, y),$$

or
determined by

$$\mathrm{Jac}(x, y) = \ln\left(2\cosh\left(\frac{x}{2} - \frac{y}{2}\right)\right) + K(x, y) \cong \left|\frac{x}{2} - \frac{y}{2}\right| + K(x, y),$$

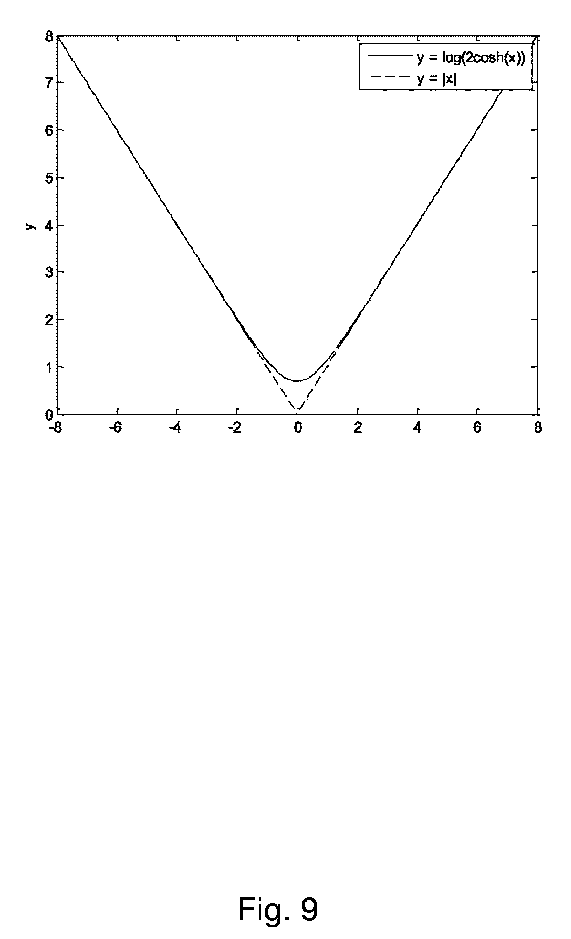

with $K(x, y) = \dfrac{x}{2} + \dfrac{y}{2}$ wherein x and y are real numbers, which are based on the information indicative of the transmit symbol, e.g. log-likelihood ratios. Fig. 9 illustrates a plot of y= log(2cosh(x)) using a solid line and y=|x| using a dashed line. As the plot in Fig. 9 illustrates there are only minor deviations in the region around x = 0. In embodiments the latter approximation might be more favorable for hardware implementation.

The variable node computation can also be simplified by this marginalization, as basically only $L_1(z_i)$ and $L_3(z_i)$ are required, amounting to $L_1(z_i) = -L_I$ and $L_3(z_i) = -L_Q$. Thus, two additions per node and outgoing edge may be carried out with two outgoing edges per node. Furthermore, all Jac-operations may be replaced by max-operations with almost no performance loss.

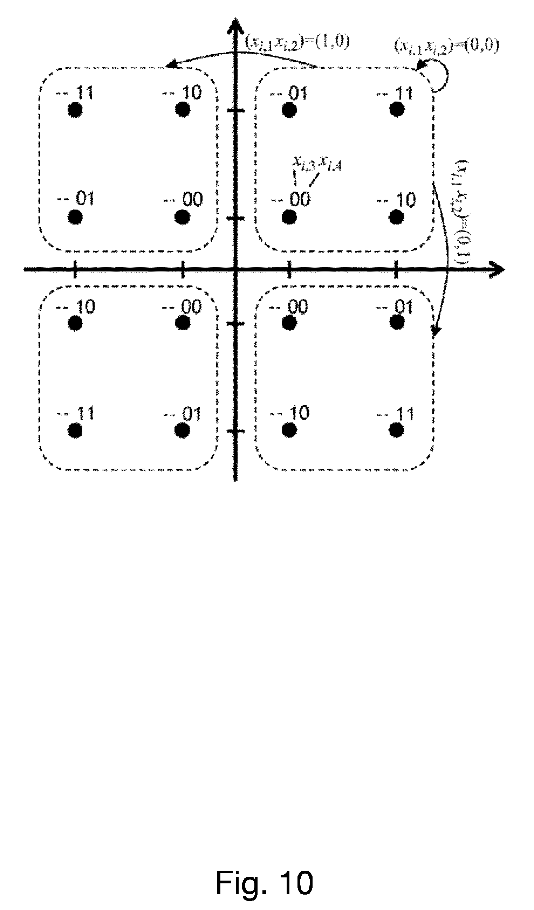

As it has been mentioned above, further embodiments may use higher order modulation, i.e. 16QAM, 64QAM, etc. Fig. 10 illustrates how differential mapping can be established when using 16QAM modulation using a corresponding constellation diagram. In order to combat phase uncertainties after signal processing at the receiver, differential encoding for the 16-QAM constellations can be utilized, cf. W. Weber, "Differential encoding for multiple amplitude and phase shift keying systems," IEEE Trans. Commun., vol. 26, no. 9, pp. 385-391, Mar. 1978. The constellation diagram illustrates that differential encoding is applied to the first two bits of the four bits of a symbol. The remaining two bits are mapped to the constellation symbols such that a phase ambiguity of k·π/2 does not affect the decision. The resulting constellation is given in Fig. 10 with some of the transitions shown for clarification. As can be seen from the constellation diagram, the mapping of the two Least Significant Bits (LSBs) is rotated between the quadrants, such that an angle between two constellation symbols having the same LSBs in adjacent quadrants corresponds to π/2. In other words, the mapping of the two LSBs is rotated counterclockwise by π/2 when comparing adjacent and counterclockwise rotated quadrants.

Four bits $x_{i,1}$, $x_{i,2}$, $x_{i,3}$, $x_{i,4}$ are mapped into TX symbol $y_i$ with

$$y_i = f_{diff}\left(x_{i,1}, x_{i,2}, y_{i-1}\right) \cdot \frac{1}{\sqrt{10}} e^{-i\frac{\pi}{4}} g\left(x_{i,3}, x_{i,4}\right),$$

Where the factor of $\dfrac{1}{\sqrt{10}}$ considers power normalization, $f_{diff}$ $(x_{i,1}, x_{i,2}, y_{i-1})=a_i$ describes the differentially encoded quadrant with $a_i \in \{\pm 1 \pm i\}$ and $g(x_{i,3}, x_{i,4})$ gives the sub-constellation in the first quadrant, e.g.

$$g\left(0,0\right) = \left(1+i\right)/\sqrt{2},$$
$$g\left(0,1\right) = \left(1+3i\right)/\sqrt{2},$$
$$g\left(1,1\right) = \left(3+3i\right)/\sqrt{2}, \text{ and}$$
$$g\left(1,0\right) = \left(3+i\right)/\sqrt{2}$$

as exemplified in Fig. 10.

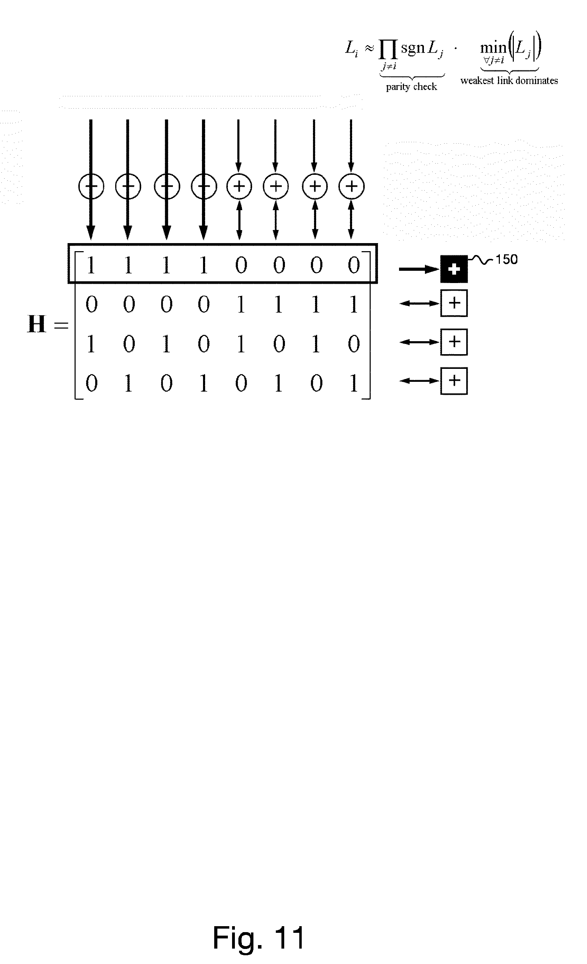

In the following a decoding example of an embodiment will be described using the illustration of Figs. 11 to 17.

Fig. 11 depicts a binary linear block code with parity-check matrix **H,** with all columns having $d_v$ ones each (variable degree $d_v$) and all rows having $d_c$ ones each (check degree $d_c$). **H** exemplifies an (N-K) x N parity-check matrix **H** for a code rate of K/N as used in an embodiment. N, K, $d_v$, and $d_c$ denote positive integer values. A codeword vector **c,** representing the received codeword, suffices $\mathbf{cH^T=0}$ (parity check condition) when being valid. **0** denotes the zero-vector. The matrix **H** shown in Fig. 11 exemplifies a variable node degree of $d_v$=2 (all columns have two "1") and a check node degree of $d_c$ = 4 (all rows have four "1").

The four arrows pointing to the four "1" of the first row of **H** on the top right of Fig. 11 illustrate that the samples of the noisy codeword received are read from the channel. Moreover, a Check Node Decoder (CND) is utilized first, evaluating

$$L_i \approx \underbrace{\prod_{j \neq i} \operatorname{sgn} L_j}_{\text{parity check}} \cdot \underbrace{\min_{\forall j \neq i}\left(\left|L_j\right|\right)}_{\text{weakest link dominates}},$$

which is an approximation to the known sum-product update rule

$$L_i = 2\operatorname{atanh}\left(\prod_{j \neq i} \tanh(L_j / 2)\right).$$

The soft information is evaluated reading the weakest link, i,j denote positive integer values. Again, the soft information is assumed to be represented by log-likelihood ratios such that the sign represents the estimated binary value and the magnitude represents the reliability or certainty of the value. The vector with the binary signs or estimates of the received codeword can then be used to carry out a parity check using **H**. The check value $L_i$ of a check node i 150 can then be determined using the above equation. Using the above equation the weakest of the other links (or considered soft information), i.e. the one with the lowest reliability, determines the reliability and the product of all other signs determines the sign of the check node value 15. This is also referred to as soft majority vote. The check note 150, which is symbolized by the dark node with the white "+" on the right of the first row of **H** in Fig. 11, can then be updated accordingly.

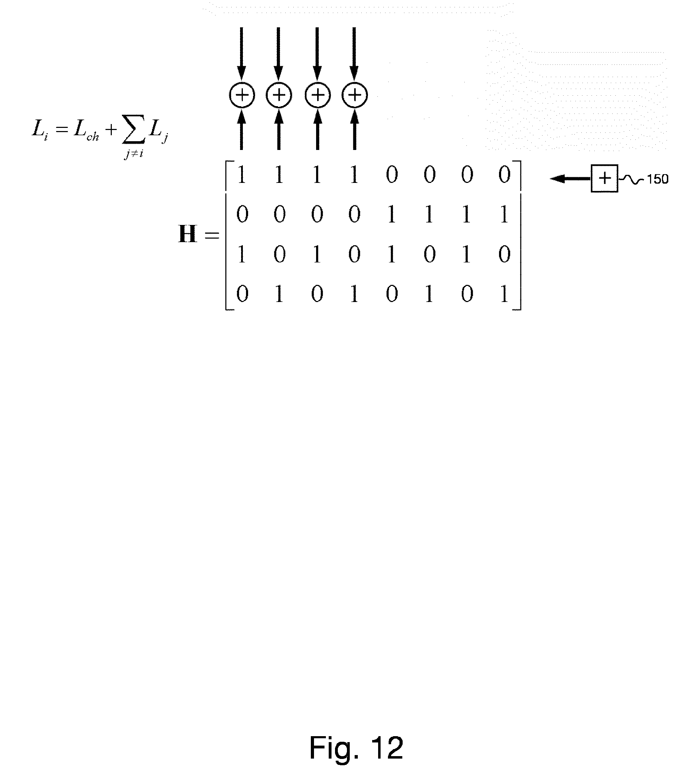

Fig. 12 illustrates the subsequent update of the variable node values by the Variable Node Decoder (VND). Feedback is provided by the check node 150 in terms of $L_j$, the variable node i can then be updated according to

$$L_i = L_{ch} + \sum_{j \neq i} L_j \ ,$$

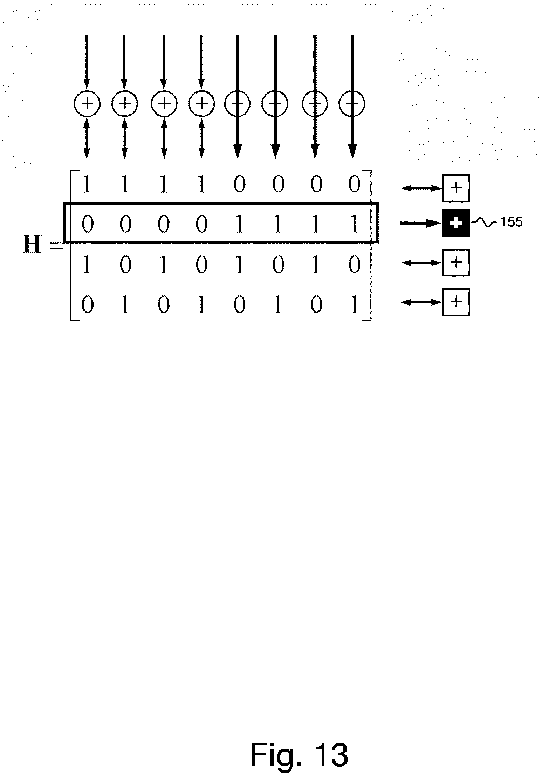

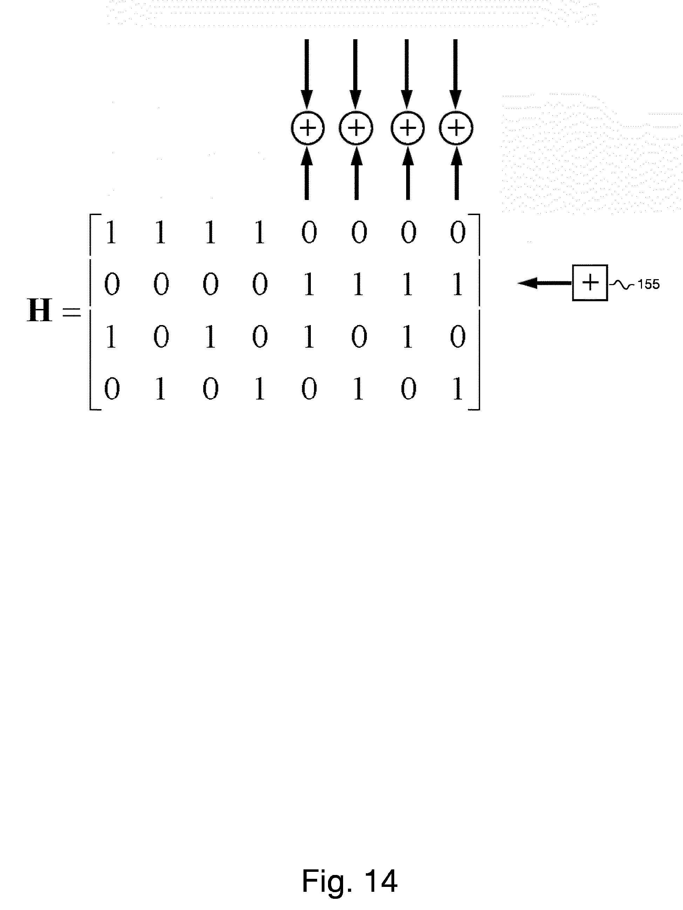

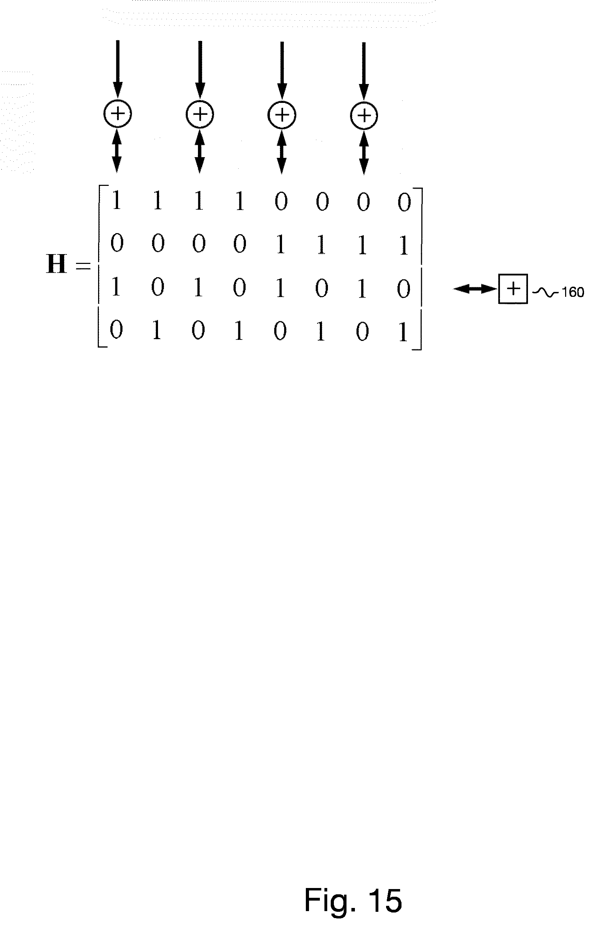

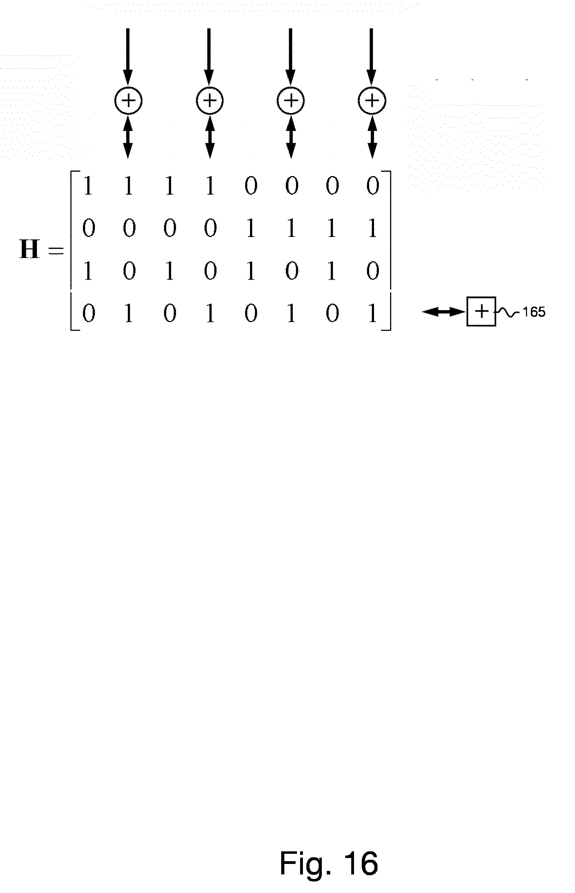

i.e. by the sum of all other log-likelihood ratios $L_j$ with $j \neq$ i and the original log-likelihood ratio $L_{ch}$, which was initially determined from the channel. Fig. 13 depicts the next step, which is similar to the step illustrated in Fig. 11, but refers to the second row of **H**. The check node 155 refers to the second row of **H** and, as indicated by the four arrows pointing to the four "1" in the second row, the respective samples are read from the channel and the check value 155 is updated per CND, accordingly. Fig. 14 illustrates the according subsequent update of the variable nodes of the second row using the VND, similar as it has been explained above for Fig. 12. Fig 15 illustrates the process for the third row of **H** using check node 160, which is updated by the CND based on the samples read from the channel before the variable nodes or values are updated by the VND. Fig. 16 illustrates the same process for the fourth row of **H** using check node 165, which is updated by the CND based on the samples read from the channel before the variable nodes or values are updated by the VND

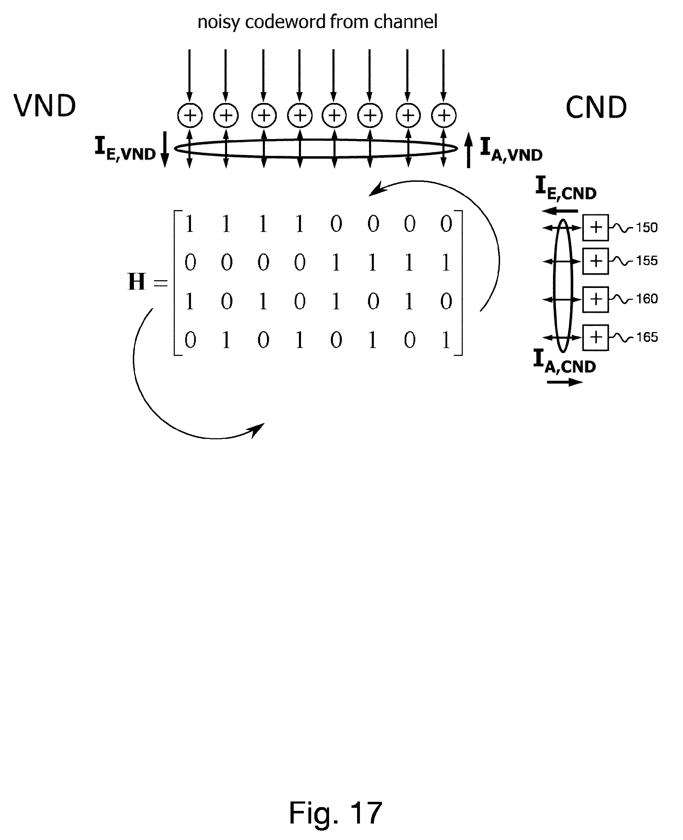

Fig. 17 displays an overview of the entire iteration. First the values read from the channel are input as soft information into the variable nodes, the values are termed $I_{E,VND}$. Based on these values the check node values can be determined, which are termed $I_{A,CND}$ using the CND. The iteration starts with the first row and the check node 150 is updated. Subsequently, the variable nodes of the first row can be updated using the updated check node values, which are termed $I_{E,CND}$, utilizing the VND outputting the updated variable values $I_{A,VND}$. The iteration then proceeds in the same manner with the second row and check node 155, the third row and check node 160, and the fourth row using check node 165. As the circular arrows indicate, the iteration may then restart with the first row based on the updated values of the variable nodes. A termination of the iteration may be determined based on the above parity check operation, i.e. the iteration may be terminated when a valid codeword has been estimated. The information flow in Fig. 17 can be used to predict the convergence and to design the respective codes.

In embodiments decoders for LDPC codes can either operate on a Tanner-Graph like description of the code or directly on the parity check matrix **H** of dimension dim**H**=$M$x$N$. In the latter case, a variant denoted row or layered decoder can be employed, which is illustrated using the sequence in Figs. 11-17. The row decoding serially processes the $M$ rows of the matrix **H**. For the example of the BPSK case, the $n$ received values are placed in the channel-related memory, cf. Fig. 11. The extended matrix according to the code reorganization in the embodiment of Fig. 3 is used and hence the channel-related memory has 2$n$ entries, where the first $n$ entries are initialized with the received values (filled variable nodes in Fig. 3) and the other $n$ entries are initialized with zero (white variable nodes in Fig. 3).

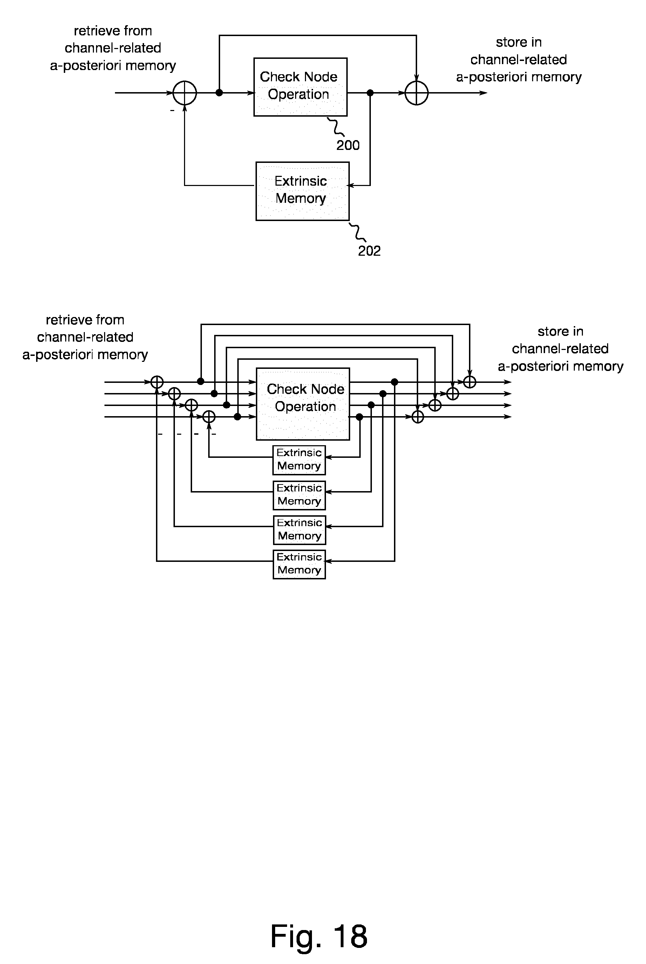

The decoder operation is depicted in Fig. 18. Fig. 18 shows two row or layered decoder implementations of embodiments. A simplified description is shown at the top and a detailed description for a check node degree $d_c$=4 is shown at the bottom. Note that the channel-related memory accesses at the left/right address the same memory location. The embodiment at the top comprises a check node operation entity 200 for the CND and extrinsic memory 202. The soft information retrieved from channel-related a-posteriori memory is combined with soft information from the extrinsic memory 202, where in the embodiment of Fig. 18 the soft information from the extrinsic memory 202 is subtracted from the soft information retrieved from the channel. The result is provided to the check node operation 200, which carries out the above described CND. The result is then stored in the extrinsic memory 202 for the next iteration. Input and extrinsic output values of the check node operation 200 are then summed before being stored in the channel related a-posteriori memory. At the bottom of Fig. 18 the check node operation uses all four inputs (corresponding to the four connections). The extrinsic memory is fourfold, i.e., there is a memory for each of the outgoing edges. Each of the left/right connection pairs addresses the same memory location, but there are four distinct memory locations or four different extrinsic memories, respectively.

It is assumed that the channel-related memory contains the a posteriori log-likelihood ratios (LLRs), i.e. the sum of all incoming edges on the variable nodes. If the current row contains four "1" the check node decoding engine retrieves the memory value of the adjacent a-posteriori LLRs. From these values $L_{v_j}^{apost}$ , the according extrinsic LLRs are subtracted (which is the incoming value from the respective edge) and then the CND operation is performed to get a new extrinsic LLR value according to

$$L^{ext}_{c \to v_i} = 2\tanh^{-1}\left(\prod_{\substack{j=1,2,3,4 \\ j \neq i}} \tanh\left(\frac{L^{in}_{v_j \to c}}{2}\right)\right) = 2\tanh^{-1}\left(\prod_{\substack{j=1,2,3,4 \\ j \neq i}} \tanh\left(\frac{L^{apost}_{v_j} - L^{ext,prev}_{c \to v_j}}{2}\right)\right),$$

which can be approximated by exploiting the fact that

$$2\tanh^{-1}(\tanh(x/2)\tanh(y/2)\tanh(z/2)) \approx \operatorname{sign}(x)\operatorname{sign}(y)\operatorname{sign}(z)\min(|x|,|y|,|z|).$$

The extrinsic output $L^{ext}_{c \to v_i}$ is stored in the extrinsic memory 202 for use in the subsequent iteration, where it becomes the new $L^{ext,prev}_{c \to v_j}$. By adding the input to the respective output of the check node row decoding engine 200, a new a-posteriori LLR is obtained, which can replace the value in the LLR memory that has been accessed at the start of the operation. Note that with this kind of decoder, no dedicated variable node computations are used as the necessary operations are included in the check node engine 200.

In a Tanner-graph like representation the variable node decoding part consists of summing the channel-related value and the incoming check node outputs at all edges except the outgoing one. As in the row decoding framework, the channel-related memory saves the a-posteriori LLRs and further by the subtraction at the input to the computation engine 200, the sum of all edges except the outgoing one is obtained. This may depend on the actual implementation in embodiments. In a Tanner-like framework, the channel-related memory may only save the incoming channel-value and only the edge-memories may be updated. However, also a-posteriori values can be saved, it may just be a matter of addition/subtraction. By adding the input to the newly computed extrinsic output, a new a-posteriori value is obtained.

At the bottom of Fig 18 four parallel row decoders are shown, which individually correspond to the single row decoder described above. Note that the row decoder can also be easily parallelized by operating in parallel on $P$ rows (with $P$ distinct engines) of **H**, which do not have any "1" in common. This means that with the odd-even interleaved representation

$$\mathbf{H'} = \left(\begin{array}{ccccccc:ccccccc} 1 & & & & & & & 1 & & & & & \\ & 1 & 1 & & & & & & 1 & & & & \\ & & & 1 & 1 & & & & & 1 & & & \\ & & & & 1 & 1 & & & & & 1 & & \\ & & & & & \ddots & \ddots & & & & & 1 & \\ 1 & 1 & & & & & & 1 & & & & & \\ & 1 & 1 & & & & & & 1 & & & & \\ & & 1 & 1 & & & & & & 1 & & & \\ & & & 1 & 1 & & & & & & 1 & & \\ & & & & \ddots & \ddots & & & & & & 1 & \\ \multicolumn{7}{c:}{\mathbf{0}} & \multicolumn{7}{c}{\mathbf{H}} \end{array}\right),$$

$P=n/2$ independent parallel computations can be carried out in principle as the first $n/2$ and the following $n/2$ rows do not have any "1" in common. In another embodiment the decoding complexity may be further reduced by switching-on or enabling only a fraction of the rows in the row decoder to perform some kind of "partial update" on the variable nodes according to some optimized schedule, which only updates those rows leading to the highest information increase.

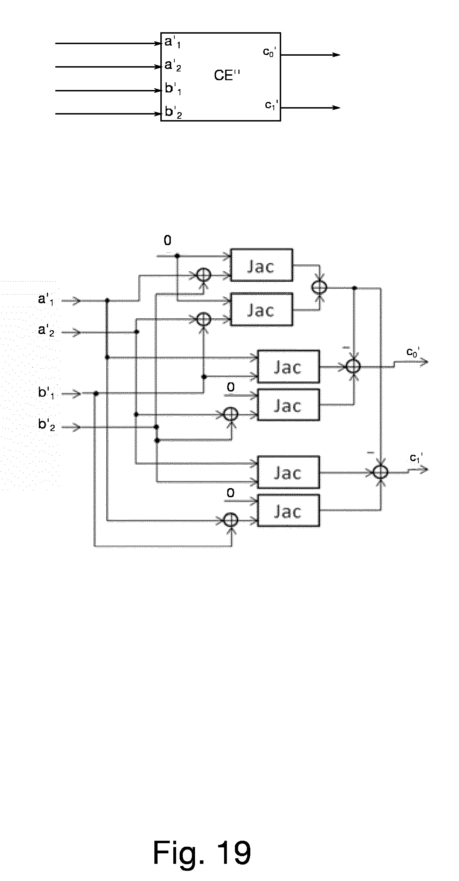

If row decoding on the differential code is used, then the computation element can be further simplified as no marginalization conversion between the binary domains is required in each step. By explicitly including the summations and differences at the $Z_4$ check node computation with marginals in each step, i.e., the summations and differences, which result from row decoding (layered decoding) and which subtract the content of the extrinsic memory from the a-posteriori memory, and operating solely on the a-posteriori LLRs (even in $Z_4$), the computation element can be further simplified by including the additions and subtractions into the computation element. In this case the CE can solely operate in the $Z_4$ domain and two of the CEs (those that do have no outgoing connection to the LDPC part of the code) can then be replaced by a simplified computing element CE". The computation CE" element to be used for computing the extrinsic output in the row decoder is shown in Fig. 19. In Fig 19 the CE for use in row decoding using the marginalization approximation is shown in a compact form at the top and in a more detailed form at the bottom. The entities labeled with "Jac" perform the Jacobian logarithms as explained in detail above. Note that for the values, which are fed to the binary LDPC variable nodes, the element CE' still may be used for the conversion to the binary case.

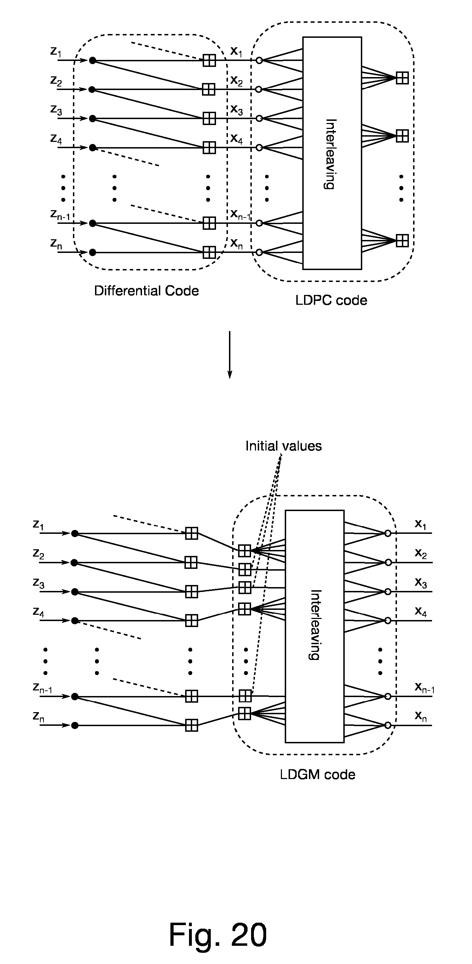

In embodiments an alternative approach based on non-systematic Irregular Repeat Accumulate (IRA) codes can be carried out. In this approach, the LDPC code is basically replaced by an LDGM (Low-Density Generator-Matrix) code followed by a differential encoder. This replacement is illustrated Fig. 20, which shows the conventional graph representation at the top, which has already been detailed with the help of Fig. 2. Note that the variable nodes and check nodes of the code party are swapped in this case, i.e., the check nodes of the differential code are connected to the check nodes of the LDGM code, as it is illustrated at the bottom of Fig. 20. The LDPC code can be replaced by a Low-Density Generator Matrix (LDGM) code followed by a differential encoder. Note that the LDGM code is extended with degree-1 check nodes (marked by the dashed lines in Fig. 20) in order to trigger or initialize decoding. The combination of LDGM code and differential code can be seen as a non-systematic irregular repeat-accumulate (NSIRA) code. Details can be found in S. ten Brink, G. Kramer, "Design of Repeat-Accumulate Codes for Iterative Detection and Decoding", IEEE Trans. Signal Proc., vol. 51, no. 11, Nov. 2003.

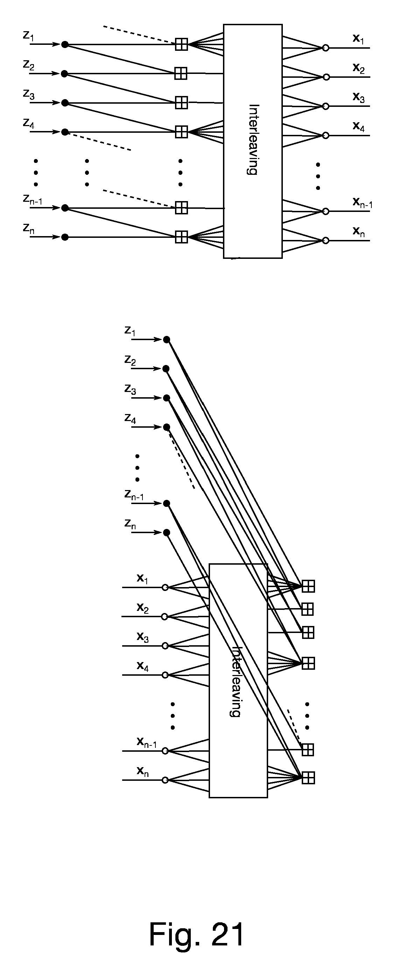

Again, the code can be re-interpreted in the same way as in Fig. 2 by redrawing the graph representation of the code. This re-interpretation is shown in Fig. 21 and can be represented by a code with parity check matrix

$$\mathbf{H'} = \begin{pmatrix} 1 & & & & (1) & \vdots & \\ 1 & 1 & & & & \vdots & \\ & 1 & \ddots & & & \vdots & \mathbf{H} \\ & & \ddots & 1 & & \vdots & \\ & & & 1 & 1 & \vdots & \end{pmatrix}.$$

Fig. 21 shows the reinterpretation of the non-systematic IRA followed by the differential encoder as an LDPC code with punctured variable nodes. The advantage of this representation in embodiments may be that the number of check nodes is reduced from $n+n-k=2n-k$ to $n$ compared with the first approach, thus reducing decoding complexity. The amount of variable nodes is also reduced from $2n$ to $n+k$ $(k < n)$ with k variable nodes (corresponding to the information bits) being interpreted as punctured (white nodes $x_{r}-x_{n}$).

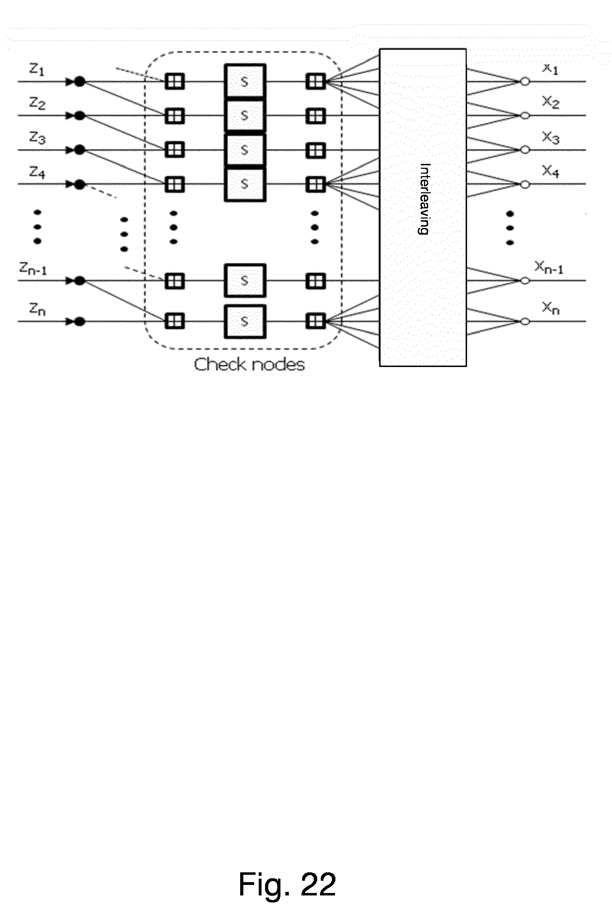

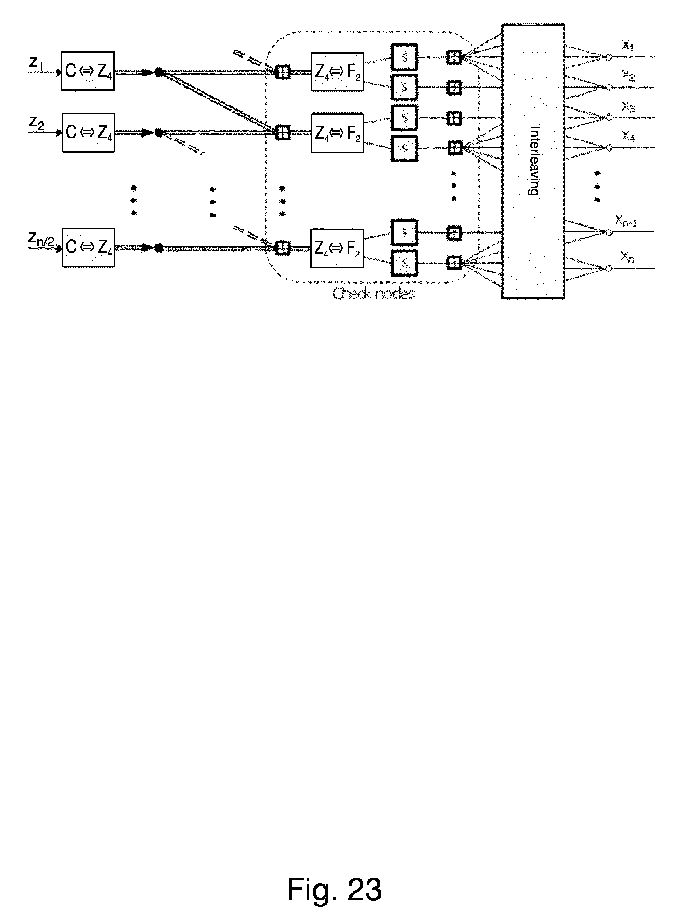

Fig. 22 shows how the S-function can be included to prevent effects from cycle slips (or phase slips) while Fig. 23 shows a possible realization for the QPSK case with a mixed domain implementation, where the NSIRA code is operating in the binary domain and the differential detector part of the code is operating in the $Z_4$ domain. In this case, the check node operation needs to consider both domains in the embodiment. Unlike the embodiment depicted in Fig. 22, the check node operation may not need to perform separate operations for the LDPC and the differential decoding in this embodiment, whose outputs are interconnected by an S-function, but within a real implementation, all of these operations can be merged into a single module/operation.

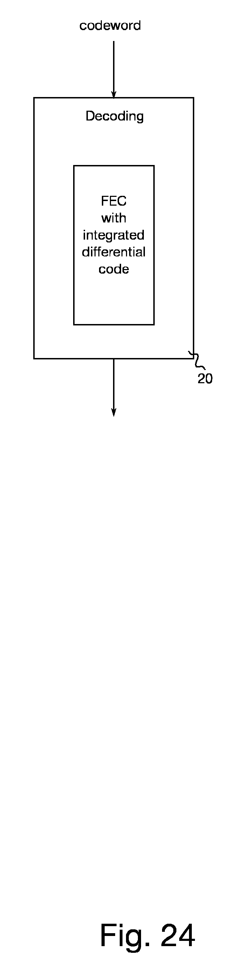

Fig. 24 shows a flow chart of an embodiment of a method for decoding a received codeword derived from an optical signal, the codeword comprising samples of QPSK modulated symbols. The received codeword being based on a transmit codeword, which is encoded by a FEC encoding rule and a subsequent differential encoding rule. The method comprises decoding 20 the received codeword based on a joint decoding scheme. The joint decoding scheme is based on a combination of a differential decoding rule associated to the differential encoding rule and a forward error correction decoding rule associated to the forward error correction encoding rule such that differential decoding is integrated into forward error correction decoding. The method further comprises mapping complex symbols from the QPSK demodulator onto finite ring Z4 using non-binary Z4 variable nodes, applying the differential decoding rule at non-binary Z4 variable nodes and non-binary check-nodes, and converting information output by said non-binary check nodes to binary LLRs for use in binary variable nodes of the forward error correction decoding rule.

Embodiments further provide a computer program having a program code for performing one of the above methods, when the computer program is executed on a computer or processor.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as magnetic disks and magnetic tapes, hard drives, or optically readable digital data storage media. The embodiments are also intended to cover computers programmed to perform said steps of the above-described methods or (field) programmable logic arrays ((F)PLAs) or application specific integrated circuits (ASIC) or (field) programmable gate arrays ((F)PGAs), programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in un-derstanding the principles of the invention and the concepts contributed by the inventor(s) to furthering the art, and are to be construed as being without limitation to such specifically recited examples and conditions. Moreover, all statements herein reciting principles, as-pects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figures, including any functional blocks labeled as "means", "means for decoding", "means for modulating", etc., may be provided through the use of dedicated hardware, such as "a decoder", "a modulator", etc. as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An apparatus (10) operable to decode a received codeword derived from an optical signal, the codeword comprising samples of QPSK modulated symbols, the received codeword being based on a transmit codeword, which is encoded by a forward error correction encoding rule and a differential encoding rule, the apparatus (10) is operable to decode the received codeword based on a joint decoding scheme, the joint decoding scheme being based on a combination of a differential decoding rule (118) associated to the differential encoding rule and a forward error correction decoding rule (122) associated to the forward error correction encoding rule such that differential decoding is integrated into forward error correction decoding,
   wherein the apparatus (10) comprises:

   means for mapping complex symbols from the QPSK demodulator onto finite ring $Z_4$;
   non-binary $Z_4$ variable nodes and non-binary check-nodes for applying the differential decoding rule, wherein the output of the mapping means is connected to said non-binary $Z_4$ variable nodes; and
   means for converting information output by said non-binary check nodes to binary LLRs for use in binary variable nodes of the forward error correction decoding rule.

2. The apparatus (10) of claim 1, being operable to carry out the joint decoding scheme based on a number of iterations, wherein in each of the iterations the combination of the differential decoding rule (118) and the forward error correction decoding rule (122) is carried out. decoding part, which is based on the differential decoding rule (118).

3. The apparatus (10) of claim 2 , being operable to determine in each iteration:

   a number of variable values, where the number of variable values corresponds to a sum of a number of symbols in the received codeword and a number of binary values represented by the number of symbols in the received codeword, and
   a number of check values, where the number of check values corresponds to a sum of the number of symbols in the received codeword and a number of parity bits introduced for the number of binary values by the forward error correction encoding rule.

4. The apparatus (10) of claim 3 , wherein the variable values and the check values correspond to information indicative of a transmit symbol and wherein the variable values and the check values are updated in each iteration.

5. The apparatus (10) of claim 4 , wherein the variable values are updated based on associated check values of a previous iteration and wherein the check values are updated based on associated variable values of the previous iteration, and wherein a check value is updated using a Jacobian logarithm of associated variable values and/or wherein a variable value is updated using a Jacobian logarithm of associated check values.

6. The apparatus (10) of claim 5 , wherein check values and variable values belonging to the differential decoding rule are represented by vectors (L(z)) of Log-likelihood Ratios and wherein the apparatus (10) is operable to convert the vectors (L(z)) of Log-likelihood Ratios to binary Log-likelihood Ratios for the check values and variable values belonging to the forward error correction decoding rule.

7. The apparatus (10) of claim 5 , wherein the Jacobian logarithm is approximated by

$$\mathrm{Jac}(x, y) = \ln(e^x + e^y) \cong \max(x, y) \,,$$

or
determined by

$$\mathrm{Jac}(x, y) = \ln\left( 2\cosh\left(\frac{x}{2} - \frac{y}{2}\right) \right) + K(x, y) \cong \left|\frac{x}{2} - \frac{y}{2}\right| + K(x, y)\,,$$

with

$$K(x, y) = \frac{x}{2} + \frac{y}{2}\,,$$

wherein x and y are real numbers, which are based on the information indicative of the transmit symbol.

8. An optical network device (30) for an optical communication system (100) comprising the apparatus (10) of claim 1.

9. A method for decoding a received codeword derived from an optical signal, the codeword comprising samples of QPSK modulated symbols, the received codeword being based on a transmit codeword, which is encoded by a forward error correction encoding rule and a differential encoding rule, the method comprisingdecoding (20) the received codeword based on a joint decoding scheme, the joint decoding scheme being based on a combination of a differential decoding rule (118) associated to the differential encoding rule and a forward error correction decoding rule (122) associated to the forward error correction encoding rule such that differential decoding is integrated into forward error correction decoding; mapping complex symbols from the QPSK demodulator onto finite ring $Z_4$ for use at non-binary $Z_4$ variable nodes; applying the differential decoding rule at said non-binary $Z_4$ variable nodes and at non-binary check-nodes; and converting information output by said non-binary check nodes to binary LLRs for use in binary variable nodes of the forward error correction decoding rule.

10. A computer program having a program code for performing the method of claim 9, when the computer program is executed on a computer or processor.

**Patentansprüche**

1. Vorrichtung (10), betreibbar für das Decodieren eines empfangenen, von einem optischen Signal abgeleiteten Codewortes, wobei das Codewort Abtastwerte von QPSK-modulierten Symbolen umfasst, wobei das empfangene Codewort auf einem Sende-Codewort basiert, welches anhand einer Vorwärtsfehlerkorrektur-Codierregel und einer differenziellen Codierregel codiert ist, wobei die Vorrichtung (10) für das Decodieren des empfangenen Codewortes auf der Basis eines gemeinsamen Decodierschemas betreibbar ist, wobei das gemeinsame Decodierschema auf einer Kombination einer mit der differenziellen Codierregel assoziierten differenziellen Decodierregel (118) und einer mit der Vorwärtsfehlerkorrektur-Codierregel (122) assoziierten Vorwärtsfehlerkorrektur-Decodierregel basiert, so dass eine differenzielle Decodierung in die Vorwärtsfehlerkorrektur-Decodierung integriert wird, wobei die Vorrichtung (10) umfasst:

Mittel zum Abbilden von komplexen Symbolen von dem QPSK-Demodulator auf einen endlichen Ring $Z_4$; nicht-binäre veränderliche Knoten $Z_4$ und nicht-binäre Prüfknoten zur Anwendung der differenziellen Decodierregel, wobei der Ausgang des Abbildungsmittels an die besagten nicht-binären veränderlichen Knoten $Z_4$ angeschlossen ist; und
Mittel zum Umwandeln der von den besagten nicht-binären Prüfknoten ausgegebenen Informationen in binäre LLRs zur Verwendung in binären veränderlichen Knoten der Vorwärtsfehlerkorrektur-Decodierregel.

2. Vorrichtung (10) nach Anspruch 1, betreibbar für das Ausführen des gemeinsamen Decodierschemas auf der Basis einer Anzahl von Iterationen, wobei in einer jeden der Iterationen die Kombination der differenziellen Decodierregel (118) und der Vorwärtsfehlerkorrektur-Decodierregel (122) ausgeführt wird.
Decodierteil, welcher auf der differenziellen Decodierregel (118) basiert.

3. Vorrichtung (10) nach Anspruch 2, betreibbar, um in jeder Iteration Folgendes zu ermitteln:

Eine Anzahl von veränderlichen Werten, wobei die Anzahl von veränderlichen Werten einer Summe einer Anzahl von Symbolen in dem empfangenen Codewort und einer Anzahl von binären Werten, welche durch die Anzahl von Symbolen in dem empfangenen Codewort dargestellt sind, entspricht, und
eine Anzahl von Prüfwerten, wobei die Anzahl von Prüfwerten einer Anzahl von Symbolen in dem empfangenen Codewort und einer Anzahl von Paritätsbits, welche für die Anzahl von binären Werten durch die Vorwärtsfehlerkorrektur-Codierregel eingebracht werden, entspricht.

4. Vorrichtung (10) nach Anspruch 3, wobei die veränderlichen Werte und die Prüfwerte Informationen, welche für ein Sende-Symbol indikativ sind, entsprechen, und wobei die veränderlichen Werte und die Prüfwerte in jeder Iteration aktualisiert werden.

5. Vorrichtung (10) nach Anspruch 4, wobei die veränderlichen Werte auf der Basis von assoziierten veränderlichen Werten der vorherigen Iteration aktualisiert werden, und wobei ein Prüfwert unter Verwendung eines Jacobi-Logarithmus von assoziierten veränderlichen Werten aktualisiert wird, und/oder wobei ein veränderlicher Wert unter Verwendung eines Jacobi-Logarithmus von assoziierten Prüfwerten aktualisiert wird.

6. Vorrichtung (10) nach Anspruch 5, wobei Prüfwerte und veränderliche Werte, welche der differenziellen Decodierregel angehören, durch Vektoren (L(z)) der Log-Likelihood-Verhältnisse dargestellt sind, und wobei die Vorrichtung (10) für die Umwandlung der Vektoren (L(z)) der Log-Likelihood-Verhältnisse in binäre Log-Likelihood-Verhältnisse für die Prüfwerte und die veränderlichen Werte, welche der Vorwärtsfehlerkorrektur-Decodierregel angehören, betreibbar ist.

7. Vorrichtung (10) nach Anspruch 5, wobei der Jacobi-Logarithmus durch

$$\mathrm{Jac}(x,\ y) = \ln(ex + ey) = \max(x,\ y),$$

approximiert, oder durch mit

$$\mathrm{Jac}(x,y) = \ln\left(2\cosh\left(\frac{x}{2} - \frac{y}{2}\right)\right) + K(x,y) \cong \left|\frac{x}{2} - \frac{y}{2}\right| + K(x,y)$$

$$K(x,y) = \frac{x}{2} + \frac{y}{2},$$

ermittelt wird, wobei x und y reelle Zahlen sind, welche auf den für das Sende-Symbol indikativen Informationen basieren.

8. Optische Netzwerkvorrichtung (30) für ein optisches Kommunikationssystem (100), umfassend die Vorrichtung (10) gemäß Anspruch 1.

9. Verfahren zum Decodieren eines empfangenen, von einem optischen Signal abgeleiteten Codewortes, wobei das Codewort Abtastwerte von QPSK-modulierten Symbolen umfasst, wobei das empfangene Codewort auf einem Sende-Codewort basiert, welches anhand einer Vorwärtsfehlerkorrektur-Codierregel und einer differenziellen Codierregel codiert ist, wobei das Verfahren das Decodieren (20) des empfangenen Codewortes auf der Basis eines gemeinsamen Decodierschemas, wobei das gemeinsame Decodierschema auf einer Kombination einer mit der differenziellen Codierregel assoziierten differenziellen Decodierregel (118) und einer mit der Vorwärtsfehlerkorrektur-Codierregel assoziierten Vorwärtsfehlerkorrektur-Decodierregel (122) basiert, so dass eine differenzielle Decodierung in die Vorwärtsfehlerkorrektur-Decodierung integriert wird;
das Abbilden von komplexen Symbolen von dem QPSK-Demodulator auf einen endlichen Ring $Z_4$ zur Verwendung an nicht-binären veränderlichen Knoten $Z_4$;
das Anwenden der differenziellen Decodierregel an den besagten nicht-binären veränderlichen Knoten $Z_4$ und an nicht-binären Prüfknoten; und
das Umwandeln der von den besagten nicht-binären Prüfknoten ausgegebenen Informationen in binäre LLRs für die Verwendung in binären veränderlichen Knoten der Vorwärtsfehlerkorrektur-Decodierregel umfasst.

10. Computerprogramm mit einem Programmcode zur Durchführung des Verfahrens gemäß Anspruch 9, wenn das Computerprogramm auf einem Computer oder Prozessor ausgeführt wird.

**Revendications**

1. Appareil (10) permettant de décoder un mot de code reçu dérivé d'un signal optique, le mot de code comprenant des échantillons de symboles modulés QPSK, le mot de code reçu étant basé sur un mot de code de transmission, qui est codé par une règle de codage de correction d'erreurs sans voie de retour et une règle de codage différentiel, l'appareil (10) permettant de décoder le mot de code reçu sur la base d'un schéma de décodage conjoint, le schéma de décodage conjoint étant basé sur une combinaison d'une règle de décodage différentiel (118) associée à la règle de codage différentiel et d'une règle de décodage de correction d'erreurs sans voie de retour (122) associée à la règle de codage de correction d'erreurs sans voie de retour de sorte que le décodage différentiel soit intégré dans le décodage de correction d'erreurs sans voie de retour,
l'appareil (10) comprenant ;
des moyens pour mettre en correspondance des symboles complexes du démodulateur QPSK sur un anneau fini $Z_4$ ;
des noeuds de variable $Z_4$ non-binaires et des noeuds de contrôle non-binaires pour appliquer la règle de décodage différentiel, dans lequel la sortie des moyens de mise en correspondance est connectée auxdits noeuds de variable $Z_4$ non-binaires ; et
des moyens pour convertir des informations délivrées en sortie par lesdits noeuds de contrôle non-binaires en LLR binaires à utiliser dans des noeuds de variable binaires de la règle de décodage de correction d'erreurs sans voie de retour.

2. Appareil (10) selon la revendication 1, permettant d'exécuter le schéma de décodage conjoint en fonction d'un nombre d'itérations, dans lequel, dans chacune des itérations, la combinaison de la règle de décodage différentiel (118) et de la règle de décodage de correction d'erreurs sans voie de retour (122) est réalisée.
partie de décodage, qui est basée sur la règle de décodage différentiel (118).

3. Appareil (10) selon la revendication 2 permettant de déterminer dans chaque itération :

un nombre de valeurs de variable, le nombre de valeurs de variable correspondant à une somme d'un nombre de symboles dans le mot de code reçu et d'un nombre de valeurs binaires représentées par le nombre de symboles dans le mot de code reçu, et
un nombre de valeurs de contrôle, le nombre de valeurs de contrôle correspondant à une somme du nombre de symboles dans le mot de code reçu et d'un nombre de bits de parité introduits pour le nombre de valeurs binaires par la règle de codage de correction d'erreurs sans voie de retour.

4. Appareil (10) selon la revendication 3, dans lequel les valeurs de variable et les valeurs de contrôle correspondent aux informations indiquant un symbole de transmission et dans lequel les valeurs de variable et les valeurs de contrôle sont mises à jour dans chaque itération.

5. Appareil (10) selon la revendication 4, dans lequel les valeurs de variable sont mises à jour en fonction de valeurs de contrôle associées d'une itération précédente et dans lequel les valeurs de contrôle sont mises à jour en fonction de valeurs de variable associées de l'itération précédente, et dans lequel une valeur de contrôle est mise à jour en utilisant un logarithme Jacobien de valeurs de variable associées et/ou dans lequel une valeur de variable est mise à jour en utilisant un logarithme Jacobien de valeurs de contrôle associées.

6. Appareil (10) selon la revendication 5, dans lequel des valeurs de contrôle et des valeurs de variable appartenant à la règle de décodage différentiel sont représentées par des vecteurs (L (z)) de rapports de vraisemblance logarithmique et l'appareil (10) permettant de convertir les vecteurs (L (z)) de rapports de vraisemblance logarithmique en rapports de vraisemblance logarithmique binaires pour les valeurs de contrôle et les valeurs de variable appartenant à la règle de décodage de correction d'erreurs sans voie de retour.

7. Appareil (10) selon la revendication 5, dans lequel le logarithme Jacobien est défini approximativement par

$$\mathrm{Jac}\,(x,\,y) = \ln\,(e^{x} + e^{y}) \cong \max\,(x,\,y),$$

ou
déterminé par

$$\mathrm{Jac}(x, y) = \ln\left(2\cosh\left(\frac{x}{2} - \frac{y}{2}\right)\right) + K(x, y) \cong \left|\frac{x}{2} - \frac{y}{2}\right| + K(x, y)$$

, avec

$$K(x, y) = \frac{x}{2} + \frac{y}{2},$$

où x et y sont des nombres réels, qui sont basés sur les informations indiquant le symbole de transmission.

8. Dispositif de réseau optique (30) pour un système de communication optique (100) comprenant l'appareil (10) selon la revendication 1.

9. Procédé pour décoder un mot de code reçu dérivé d'un signal optique, le mot de code comprenant des échantillons de symboles modulés QPSK, le mot de code reçu étant basé sur un mot de code de transmission, qui est codé par une règle de codage de correction d'erreurs sans voie de retour et une règle de codage différentiel, le procédé comprenant le décodage (20) du mot de code reçu sur la base d'un schéma de décodage conjoint, le schéma de décodage conjoint étant basé sur une combinaison d'une règle de décodage différentiel (118) associée à la règle de codage différentiel et d'une règle de décodage de correction d'erreurs sans voie de retour (122) associée à la règle de codage de correction d'erreurs sans voie de retour de sorte que le décodage différentiel soit intégré dans le décodage de correction d'erreurs sans voie de retour ;

mettre en correspondance des symboles complexes du démodulateur QPSK sur un anneau fini $Z_4$ à utiliser au niveau de noeuds de variable $Z_4$ non-binaires ;

appliquer la règle de décodage différentiel au niveau desdits noeuds de variable $Z_4$ non-binaires et au niveau des noeuds de contrôle non-binaires ; et

convertir des informations délivrées en sortie par lesdits noeuds de contrôle non-binaires en LLR binaires à utiliser dans des noeuds de variable binaires de la règle de décodage de correction d'erreurs sans voie de retour.

10. Programme informatique possédant un code de programme pour exécuter le procédé selon la revendication 9, lorsque le programme informatique est exécuté sur un ordinateur ou un processeur.

Fig. 1

Fig. 2

Fig. 3

Fig. 4

Fig. 5

Fig. 6

Fig. 7

Fig. 8

Fig. 9

Fig. 10

$$L_i \approx \underbrace{\prod_{j \neq i} \operatorname{sgn} L_j}_{\text{parity check}} \cdot \underbrace{\min_{\forall j \neq i} \left( \left| L_j \right| \right)}_{\text{weakest link dominates}}$$

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

150

Fig. 11

$$L_i = L_{ch} + \sum_{j \neq i} L_j$$

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

150

# Fig. 12

Fig. 13

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

$\leftarrow \boxed{+} \sim 155$

Fig. 14

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

Fig. 15

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

⟷ $\boxed{+}$ ⌇ 165

# Fig. 16

noisy codeword from channel

VND

CND

$$\mathbf{H} = \begin{bmatrix} 1 & 1 & 1 & 1 & 0 & 0 & 0 & 0 \\ 0 & 0 & 0 & 0 & 1 & 1 & 1 & 1 \\ 1 & 0 & 1 & 0 & 1 & 0 & 1 & 0 \\ 0 & 1 & 0 & 1 & 0 & 1 & 0 & 1 \end{bmatrix}$$

$\mathbf{I}_{E,VND}$

$\mathbf{I}_{A,VND}$

$\mathbf{I}_{E,CND}$

+ ~150
+ ~155
+ ~160
+ ~165

$\mathbf{I}_{A,CND}$

Fig. 17

retrieve from
channel-related
a-posteriori memory

Check Node
Operation

store in
channel-related
a-posteriori memory

-

200

Extrinsic
Memory

202

retrieve from
channel-related
a-posteriori memory

Check Node
Operation

store in
channel-related
a-posteriori memory

Extrinsic
Memory

Extrinsic
Memory

Extrinsic
Memory

Extrinsic
Memory

Fig. 18

45

Fig. 19

Fig. 20

Fig. 21

Fig. 22

# Fig. 23

codeword

Decoding

FEC
with
integrated
differential
code

20

Fig. 24

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 11305776 A

### Non-patent literature cited in the description

- **M. FRANCESCHINI ; G. FERRARI ; R. RAHELI ; A. CURTONI.** Serial concatenation of LDPC codes and differential modulations. *IEEE Trans. Commun.,* September 2005, vol. 23 (9), 1758-1768
- **L. R. BAHL ; J. COCKE ; F. JELINEK ; J. RAVIV.** Optimal Decoding of Linear Codes for minimizing symbol error rate. *IEEE Transactions on Information Theory,* March 1974, vol. IT-20 (2), 284-287
- **JIANRONG BAO et al.** Concatenated eIRA Codes for Tamed Frequency Modulation. *IEEE International Conference on Communications, ICC'08,* 19 May 2008, 1886-1891
- **FRANK R. KSCHISCHANG ; BRENDAN J. FREY ; HANS-ANDREA LOELIGER.** Factor graphs and the sum-product algorithm. *IEEE TRANSACTIONS ON INFORMATION THEORY,* February 2001, vol. 47 (2
- **J. HAGENAUER ; E. OFFER ; L. PAPKE.** Iterative Decoding of Binary Block and Convolutional Codes. *IEEE TRANSACTIONS ON INFORMATION THEORY,* March 1996, vol. 42 (2
- **S. BENEDETTO ; D. DIVSALAR ; G. MONTORSI ; F. POLLARA.** A Soft-Input Soft-Output APP Module for Iterative Decoding of Concatenated Codes. *IEEE COMMUNICATIONS LETTERS,* January 1997, vol. 1 (1
- **J. HAGENAUER ; E. OFFER ; L. PAPKE.** Iterative Decoding of Binary Block and Convolutional Codes. *IEEE Trans. Inform. Theory,* March 1996, vol. 42 (2
- **H. WYMEERSCH ; H. STEENDAM ; M. MOENE-CLAEY.** Log-Domain Decoding of LDPC codes over GF(q). *IEEE Conf. on Communications (ICC),* 2004
- **W. WEBER.** Differential encoding for multiple amplitude and phase shift keying systems. *IEEE Trans. Commun.,* March 1978, vol. 26 (9), 385-391
- **S. TEN BRINK ; G. KRAMER.** Design of Repeat-Accumulate Codes for Iterative Detection and Decoding. *IEEE Trans. Signal Proc.,* November 2003, vol. 51 (11